# EUROPEAN PATENT APPLICATION

(11) **EP 4 766 115 A1**
(43) Date of publication of application: **24.06.2026**
(21) Application number: 25205371.5
(22) Date of filing: 29.09.2025
(51) Int. Cl.: H10K 59/122, H10K 59/80

(54) **DISPLAY DEVICE, ELECTRONIC DEVICE INCLUDING DISPLAY DEVICE, AND METHOD OF PROVIDING THE SAME**

(30) Priority: 17.12.2024 KR 20240187939
(71) Applicant: Samsung Display Co., Ltd., Yongin-si, Gyeonggi-do 17113 (KR)
(72) Inventor: YANG, Hee Jun, Yongin-si (KR)
(74) Representative: Marks & Clerk LLP

(57) **Abstract**

A display device includes a bank structure in which an anode contact hole is defined in an emission area, the bank structure having a side surface defining the anode contact hole and an overhang structure which is in the non-emission area, a first insulating layer on the bank structure and extended into the anode contact hole to cover the side surface of the bank structure, an anode of a light emitting element, on the first insulating layer and in the emission area, the anode including first and second conductive layers facing each other in the emission area, an organic anode planarization layer between the first and second conductive layer in the emission area, and a second insulating layer covering an edge of the anode and in which an opening is defined overlapping the anode contact hole, the second insulating layer contacting the first insulating layer.

## Description

### BACKGROUND

### 1. Field

The present disclosure relates to a display device, an electronic device using the display device, and a method of fabricating (or providing) the display device.

### 2. Description of the Related Art

As the information society develops, demands for display devices for displaying images are increasing in various forms. For example, display devices are applied to various electronic devices such as smartphones, digital cameras, notebook computers, navigation devices, and smart televisions. The display devices may be flat panel display devices such as liquid crystal display devices, field emission display devices, and organic light emitting display devices. Among these flat panel display devices, a light emitting display device includes a light emitting element which enables each pixel of a display panel to emit light by itself. Thus, the light emitting display device can display an image without a backlight unit which provides light to the display panel.

### SUMMARY

An aspect of the present disclosure provides a display device capable of providing a high-resolution image, an electronic device using the display device, and a method of fabricating (or providing) the display device.

An aspect of the present disclosure is to solve a reliability defect of a light emitting element included in a display device.

However, aspects of the present disclosure are not restricted to the one set forth herein. The above and other aspects of the present disclosure will become more apparent to one of ordinary skill in the art to which the present disclosure pertains by referencing the detailed description of the present disclosure given below.

In an embodiment of the disclosure, there is provided a display device including a substrate including an emission area and a non-emission area, a bank structure located on the emission area of the substrate and having an overhang structure, an anode contact hole overlapping the emission area and penetrating the bank structure, a first element insulating layer located on the bank structure and overlapping the anode contact hole to cover a side surface of the bank structure, an anode located on the first element insulating layer and including a first conductive layer and a second conductive layer which include a metal material, an anode planarization layer overlapping the anode contact hole, including an organic material, and located between the first conductive layer and the second conductive layer, and a second element insulating layer covering an edge of the anode, defining an opening, and contacting the first element insulating layer.

In an embodiment, the bank structure may include a first bank layer, a second bank layer located on the first bank layer, and a third bank layer having a tip which protrudes more than a first side surface of the second bank layer toward the non-emission area, where the anode planarization layer overlaps the anode contact hole to penetrate the first bank layer, the second bank layer and the third bank layer.

In an embodiment, the first conductive layer may be spaced apart from the first bank layer, the second bank layer and the third bank layer with the first element insulating layer interposed therebetween.

In an embodiment, the first conductive layer may include a step in a portion overlapping the anode contact hole, and the anode planarization layer flattens the step formed by the first conductive layer.

In an embodiment, the display device may include a first light emitting layer located on the anode and covering an entirety of second element insulating layer, a cathode located on the first light emitting layer, and an auxiliary electrode located on the cathode and contacting the tip of the third bank layer.

In an embodiment the auxiliary electrode may contact the first side surface of the second bank layer and, in a portion overlapping the non-emission area, spaced apart from the first bank layer in a direction perpendicular to the substrate.

In an embodiment the anode planarization layer may contact the first conductive layer and the second conductive layer and may be completely surrounded by the first conductive layer and the second conductive layer.

In an embodiment the second conductive layer may include a first portion which contacts the anode planarization layer and a second portion which contacts the first conductive layer.

In an embodiment the first conductive layer and the second conductive layer of the anode may contact each other in the portion overlapping the non-emission area, and the anode planarization layer does not overlap the non-emission area.

In an embodiment the anode planarization layer may include a first surface which faces the second conductive layer, and the first surface is a curved surface.

In an embodiment the first surface may be convex in a direction toward the second conductive layer.

In an embodiment the first surface may be concave in a direction toward the substrate.

In an embodiment of the disclosure, there is provided a method for fabricating a display device, the method including forming an anode contact hole which penetrates a bank structure and a first element insulating layer, forming a first conductive layer of an anode, an anode planarization layer, and a second conductive layer of the anode, forming a tip of the bank structure after forming a second element insulating layer which defines an opening, and forming a light emitting layer, a cathode, an auxiliary electrode, and an element inorganic layer on the anode.

In an embodiment, in the forming of the first conductive layer of the anode, the anode planarization layer, and the second conductive layer of the anode, a portion of the anode planarization layer may be removed by performing a chemical mechanical polishing (CMP) process, the anode planarization layer includes a first surface which contacts the second conductive layer of the anode, and the first surface includes a surface polished by the CMP process.

In an embodiment of the disclosure, there is provided an electronic device including at least one display device including a substrate which includes an emission area and a non-emission area, and at least any one of a display module, a processor, a memory, and a power module connected to the at least one display device, where the at least one display device includes a bank structure located on the emission area of the substrate and having an overhang structure, an anode contact hole overlapping the emission area and penetrating the bank structure, a first element insulating layer located on the bank structure and overlapping the anode contact hole to cover a side surface of the bank structure, an anode located on the first element insulating layer and including a first conductive layer and a second conductive layer which include a metal material, an anode planarization layer overlapping the anode contact hole, including an organic material, and located between the first conductive layer and the second conductive layer, and a second element insulating layer covering an edge of the anode, defining an opening, and contacting the first element insulating layer.

At least some of the above and other features of the invention are set out in the claims.

According to the embodiments of the present disclosure, a high-resolution display device can be provided. In addition, it is possible to solve the reliability defect of the light emitting device included in the display device.

It should be noted that effects of the present disclosure are not limited to those described above and other effects of the present disclosure will be apparent to those skilled in the art from the following descriptions.

### BRIEF DESCRIPTION OF THE DRAWINGS

These and/or other features will become apparent and more readily appreciated from the following description of the embodiments, taken in conjunction with the accompanying drawings in which:
FIG. 1 is a perspective view of a display device according to an embodiment;
FIG. 2 is a cross-sectional view of the display device according to the embodiment;
FIG. 3 is a plan view of a display layer of the display device according to the embodiment;
FIG. 4 is an enlarged plan view illustrating the arrangement of a plurality of pixels in a display area of FIG. 3;
FIG. 5 is a cross-sectional view of an example of the display layer taken along line A1-A1' of FIG. 4;
FIG. 6 is an enlarged cross-sectional view of a display element layer overlapping a first emission area in FIG. 5;
FIG. 7 is an enlarged cross-sectional view of area 'A' in FIG. 6;
FIG. 8 is an embodiment and an enlarged cross-sectional view of area 'A' in FIG. 6;
FIG. 9 is an embodiment and an enlarged cross-sectional view of area 'A' in FIG. 6;
FIG. 10 is a flowchart illustrating a method of fabricating the display element layer of FIG. 5;
FIGS. 11 through 13 are cross-sectional views illustrating operation S100 of FIG. 10;
FIGS. 14 through 17 are cross-sectional views illustrating operation S200 of FIG. 10;
FIGS. 18 through 21 are cross-sectional views illustrating operation S300 of FIG. 10;
FIGS. 22 through 25 are cross-sectional views illustrating operation S400 of FIG. 10;
FIG. 26 is a block diagram of an electronic device according to an embodiment; and
FIG. 27 is a schematic diagram of electronic devices according to various embodiments.

### DETAILED DESCRIPTION

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being related to another element such as being "on" another element or layer, the element or layer can be directly on another element or layer or intervening elements or layers. In contrast, when an element or layer is referred to as being related to another element such as being "directly on" another element or layer, no intervening element or layer is present therebetween.

Like reference numerals refer to like elements throughout the specification. Within the Figures and the text of the disclosure, a reference number indicating a singular form of an element may also be used to reference a plurality of the element. Shapes, sizes, ratios, angles, numbers, etc. disclosed in the drawings for describing embodiments are merely an example, and the present disclosure is not limited to the illustrated details.

It will be understood that, although the terms first, second, third, etc., may be used herein to describe various elements, these elements should not be limited by these terms. These terms are only used to distinguish one element from another element. Thus, a first element discussed below could be termed a second element without departing from the teachings of the present disclosure.

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. Thus, reference to "an" element in a claim followed by reference to "the" element is inclusive of one element and a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. It will be further understood that the terms "includes" and/or "including," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompass both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Embodiments are described herein with reference to cross section illustrations that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, embodiments will be described with reference to the accompanying drawings.

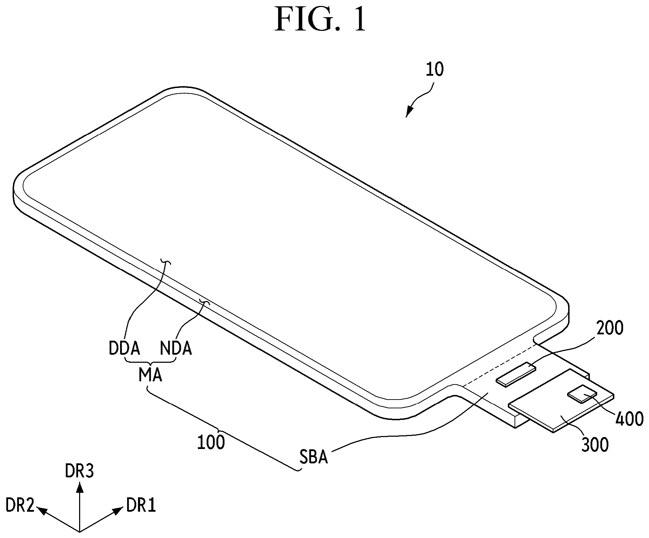

FIG. 1 is a perspective view of a display device 10 according to an embodiment.

Referring to FIG. 1, the display device 10 may be applied to portable electronic devices such as mobile phones, smartphones, tablet personal computers (PCs), mobile communication terminals, electronic notebooks, electronic books, portable multimedia players (PMPs), navigation devices, and ultra-mobile PCs (UMPCs). For example, the display device 10 may be applied as a display unit of a television, a notebook computer, a monitor, a billboard, or an Internet of things (IoT) device. For another example, the display device 10 may be applied to wearable devices such as smart watches, watch phones, glasses-type displays, and head mounted displays (HMDs).

The display device 10 may have a planar shape similar to a quadrangle. For example, the display device 10 may have a planar shape similar to a quadrangle having short sides in a first direction DR1 and long sides in a second direction DR2. Each corner where a short side extending in the first direction DR1 meets a long side extending in the second direction DR2 may be rounded to have a predetermined curvature or may be right-angled, in a plan view. The planar shape of the display device 10 is not limited to a quadrangular shape but may also be similar to other polygonal shapes, a circular shape, or an oval shape.

The display device 10 may include a display panel 100, a display driver 200, a circuit board 300, and a touch driver 400.

The display panel 100 may include a main area MA and a sub-area SBA which together provide a total planar area of the display panel 100 which is flat. The main area MA may include a display area DDA including pixels PX which display an image and a non-display area NDA which is adjacent to the display area DDA, such as being located around the display area DDA in the plan view.

The display area DDA may emit light from a plurality of emission areas or a plurality of openings which will be described later. For example, the display panel 100 may include a pixel circuit in a circuit layer including switching elements, an element insulating layer defining an emission area or an opening, and a self-light emitting element. For example, the self-light emitting element may include, but is not limited to, at least one of an organic light emitting diode including an organic light emitting layer, a quantum dot light emitting diode including a quantum dot light emitting layer, an inorganic light emitting diode including an inorganic semiconductor, and a micro light emitting diode. The drawings below illustrate a case where the self-light emitting element is an organic light emitting diode.

The non-display area NDA may be an area outside the display area DDA. The non-display area NDA may be defined as an edge area of the main area MA of the display panel 100, such as being closer to an outer edge of the display device 10. The non-display area NDA may be in the main area MA and the sub-area SBA, without being limited thereto.

The sub-area SBA may extend from a side of the main area MA. The sub-area SBA may include a flexible material which can be bent, folded, rolled, etc. For example, when the display device 10 is bent at the sub-area SBA, the sub-area SBA may be overlapped by the main area MA in (or along) a thickness direction (e.g., a third direction DR3). The sub-area SBA may include the display driver 200 and a pad unit which is connected to the circuit board 300. In an embodiment, the sub-area SBA may be omitted, and the display driver 200 and the pad unit may be located in the non-display area NDA.

The display driver 200 may output signals and voltages for driving the display panel 100. The display driver 200 may be formed (or provided) as an integrated circuit and mounted on the display panel 100 by a chip on glass (COG) method, a chip on plastic (COP) method, or an ultrasonic bonding method. For example, the display driver 200 may be located in the sub-area SBA and may be overlapped by the main area MA in the thickness direction by the bending of the display panel 100 at the sub-area SBA. For another example, the display driver 200 may be mounted on the circuit board 300.

The circuit board 300 may be attached onto the pad unit of the display panel 100 using an anisotropic conductive film (ACF). The circuit board 300 may be a flexible printed circuit board, a printed circuit board, or a flexible film such as a chip on film.

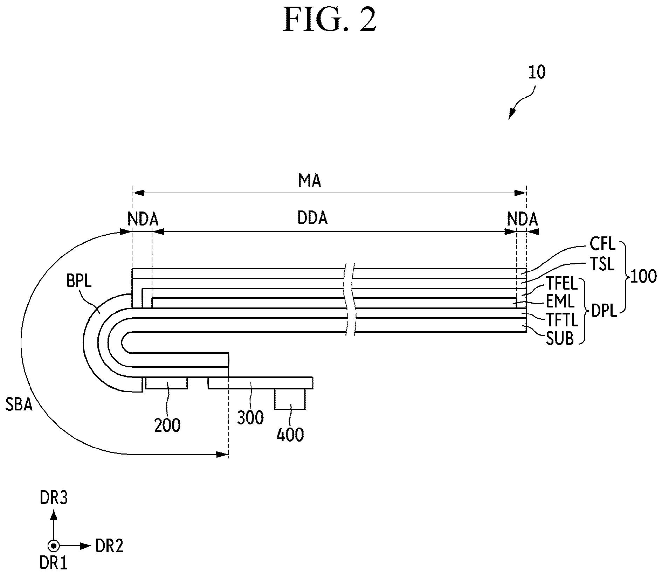

The touch driver 400 may be mounted on the circuit board 300. The touch driver 400 may be connected to a touch sensor layer TSL (see FIG. 2) for sensing and driving a touch as an external input.

FIG. 2 is a cross-sectional view of the display device 10 according to the embodiment.

Referring to FIG. 2, the display panel 100 may include a display layer DPL, the touch sensor layer TSL, and a color filter layer CFL. The display layer DPL may include a substrate SUB, a transistor layer TFTL, a display element layer EML, and an encapsulation layer such as a thin-film encapsulation layer TFEL.

The substrate SUB may be a base substrate or a base member. The substrate SUB may be a flexible substrate which can be bent, folded, rolled, etc. For example, the substrate SUB may include polymer resin such as polyimide (PI), but embodiments are not limited thereto. In an embodiment, the substrate SUB may include a glass material or a metal material.

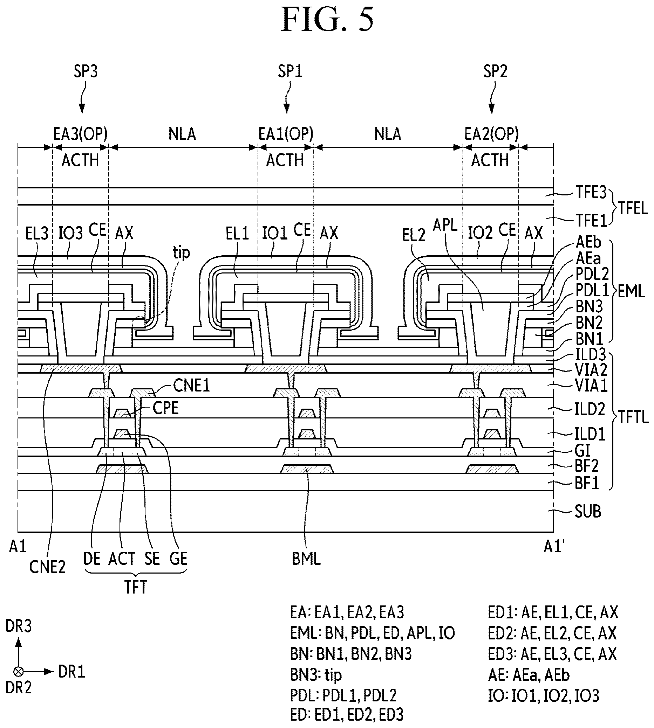

The transistor layer TFTL may be located on the substrate SUB. The transistor layer TFTL may be located in portions overlapping the display area DDA, the non-display area NDA, and the sub-area SBA. The transistor layer TFTL may include a plurality of transistors TFT (see FIG. 5).

The display element layer EML may be located on the transistor layer TFTL. The display element layer EML may be located in a portion overlapping the display area DDA. The display element layer EML may include, but is not limited to, at least one of an organic light emitting diode including an organic light emitting layer, a quantum dot light emitting diode including a quantum dot light emitting layer, an inorganic light emitting diode including an inorganic semiconductor, and a micro light emitting diode.

The thin-film encapsulation layer TFEL may be located on the display element layer EML. The thin-film encapsulation layer TFEL may be located in portions overlapping the display area DDA and the non-display area NDA. The thin-film encapsulation layer TFEL may cover upper and side surfaces of the display element layer EML and may protect the display element layer EML from external oxygen and moisture. The thin-film encapsulation layer TFEL may include at least one inorganic layer and at least one organic layer to encapsulate the display element layer EML. The thin-film encapsulation layer TFEL can be omitted depending on embodiments.

The touch sensor layer TSL may be located on the thin-film encapsulation layer TFEL. The touch sensor layer TSL may be located in the portions overlapping the display area DDA and the non-display area NDA. The touch sensor layer TSL may sense an external input such as a user's touch in a mutual capacitance manner or a self-capacitance manner. The touch sensor layer TSL can be omitted depending on embodiments.

The color filter layer CFL may be located on the touch sensor layer TSL. The color filter layer CFL may be located in the portions overlapping the display area DDA and the non-display area NDA. The color filter layer CFL may absorb a part of light coming from the outside of the display device 10, thereby reducing reflected light caused by the external light. Therefore, the color filter layer CFL can prevent color distortion caused by reflection of external light.

Since the color filter layer CFL is directly disposed on the touch sensor layer TSL, the display device 10 may not require a separate substrate for the color filter layer CFL. Therefore, a thickness of the display device 10 may be relatively small. The color filter layer CFL can be omitted depending on embodiments.

As illustrated in FIG. 2, a portion of the display panel 100 which overlaps the sub-area SBA may be bent. When the portion of the display panel 100 is bent at the sub-area SBA, the display driver 200, the circuit board 300, and the touch driver 400 may be overlapped by the main area MA, in the third direction DR3.

When the portion of the display panel 100 is bent, a bending protection layer BPL may protect a structure or layers located thereunder and overlapping the sub-area SBA from bending stress.

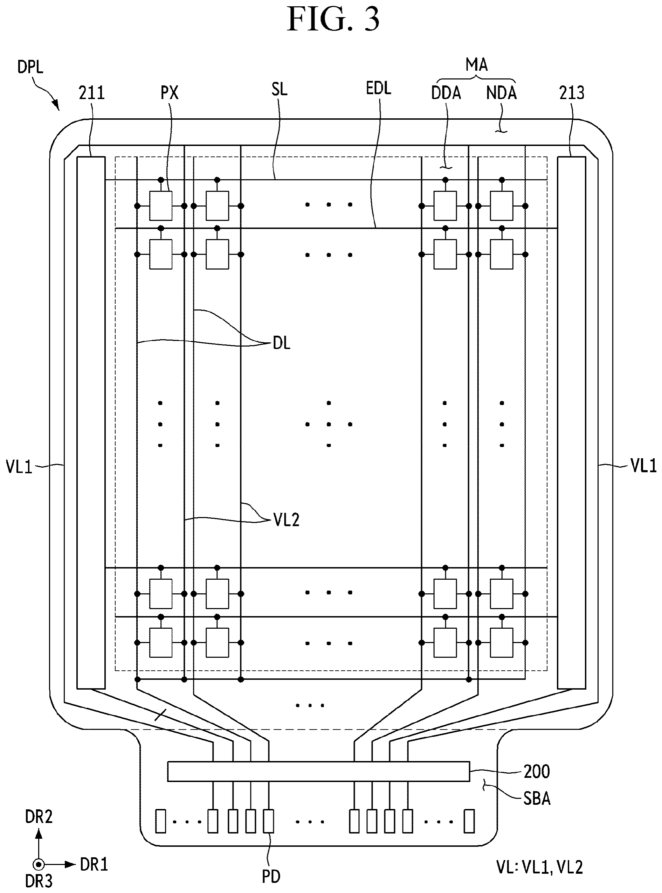

FIG. 3 is a plan view of the display layer DPL of the display device 10 according to the embodiment.

Referring to FIG. 3, the display layer DPL may include a pixel PX provided in plural including a plurality of pixels PX, and a plurality of power lines VL, a scan line SL provided in plural including a plurality of scan lines SL, an emission control line EDL provided in plural including a plurality of emission control lines EDL, and a data line DL provided in plural including a plurality of data lines DL connected to the pixels PX, in a portion overlapping the display area DDA.

The scan lines SL may extend in the first direction DR1 and may be spaced apart from each other in the second direction DR2 which intersects the first direction DR1. The scan lines SL may be arranged along the second direction DR2. The scan lines SL may sequentially supply scan signals to the pixels PX.

The emission control lines EDL may extend in the first direction DR1 and may be spaced apart from each other in the second direction DR2. The emission control lines EDL may be arranged along the second direction DR2. The emission control lines EDL may sequentially supply emission signals to the pixels PX.

The data lines DL may extend in the second direction DR2 and may be spaced apart from each other in the first direction DR1. The data lines DL may be arranged along the first direction DR1. The data lines DL may supply data voltages to the pixels PX. The data voltages may determine luminances of the pixels PX.

The power lines VL may include a main power line VL1 and sub-power lines VL2. At least any one of a first power voltage (high potential voltage) and a second power voltage (low potential voltage) may be transmitted to the sub-power lines VL2 through the main power line VL1 overlapping the non-display area NDA. The main power line VL1 and the sub-power lines VL2 may be collectively referred to as the power lines VL.

The non-display area NDA may surround the display area DDA in the plan view (e.g., a view along the third direction DR3). The non-display area NDA may include a scan driver 211 and an emission control driver 213.

The scan driver 211 may be disposed outside one side of the display area DDA or on one side of the non-display area NDA. The scan driver 211 may include a plurality of driving transistors which generate gate signals based on a gate control signal.

The emission control driver 213 may be disposed outside the other side of the display area DDA or on the other side of the non-display area NDA. The emission control driver 213 may include a plurality of emission control transistors which generate emission signals based on an emission control signal.

The display layer DPL included in an embodiment may include the display driver 200 and a pad electrode PD which is provided in plural including a plurality of pad electrodes PD, in a portion overlapping the sub-area SBA. The pad electrodes PD may be spaced apart from each other in the first direction DR1 and may be connected to different signal lines, respectively.

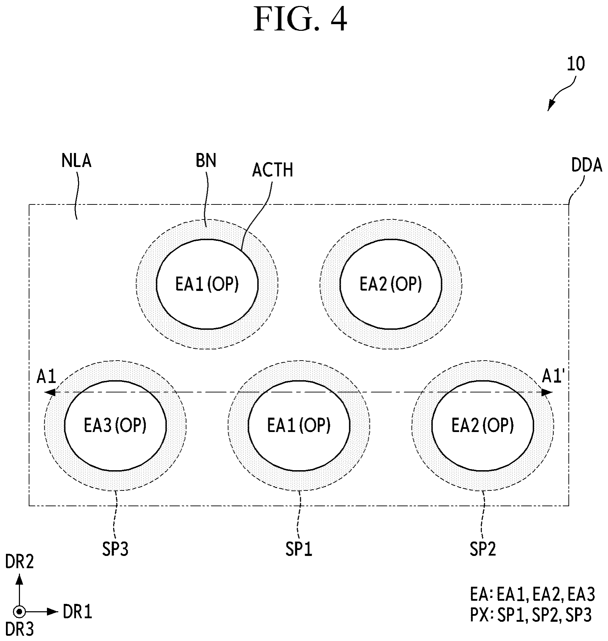

FIG. 4 is an enlarged plan view illustrating the arrangement of a plurality of pixels PX in the display area DDA of FIG. 3.

Referring to FIG. 4, each of the pixels PX of an embodiment may include a first subpixel SP1, a second subpixel SP2, and a third subpixel SP3 located in a portion overlapping the display area DDA. The first subpixel SP1, the second subpixel SP2, and the third subpixel SP3 may be spaced apart from each other.

The pixels PX may include emission areas EA. The emission areas EA may be portions or planar areas from which light is emitted. For example, the first subpixel SP1 may include a first emission area EA1, the second subpixel SP2 may include a second emission area EA2, and the third subpixel SP3 may include a third emission area EA3.

In an embodiment, the first emission area EA1, the second emission area EA2, and the third emission area EA3 may emit light of different colors. For example, the first emission area EA1 may emit red light, the second emission area EA2 may emit green light, and the third emission area EA3 may emit blue light. However, embodiments are not limited thereto. Depending on embodiments, the first emission area EA1, the second emission area EA2, and the third emission area EA3 can also emit light of the same color.

In an embodiment, the emission areas EA may be defined by openings OP, respectively. The openings OP may be defined by an element insulating layer PDL (see FIG. 5) which will be described later.

In the plan view, anode contact holes ACTH are located in portions overlapping the emission areas EA. In other words, in the plan view, the anode contact holes ACTH may be located in portions overlapping the openings OP. The anode contact holes ACTH will be described later.

The display device 10 of the embodiment may include a non-emission area NLA in the portion overlapping the display area DDA. The non-emission area NLA may prevent color mixing of light emitted from the first emission area EA1, the second emission area EA2, and the third emission area EA3.

A bank structure BN may be located in a portion overlapping the non-emission area NLA. The bank structure BN may surround the openings OP or the anode contact holes ACTH.

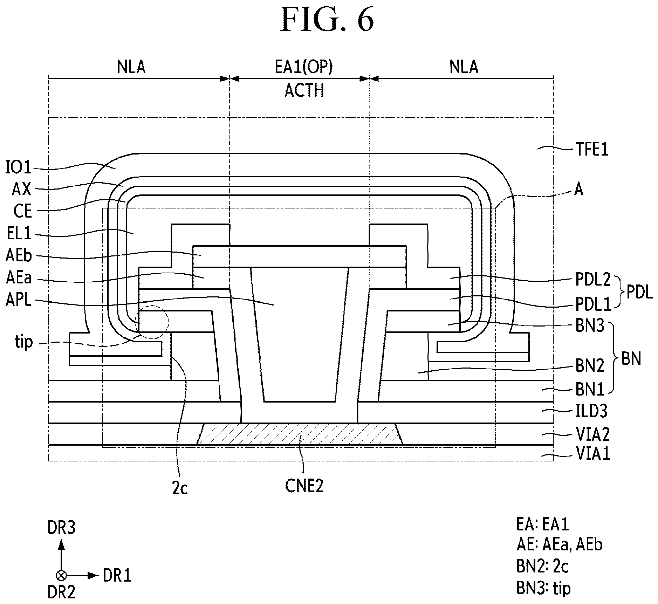

FIG. 5 is a cross-sectional view of an example of the display layer DPL taken along line A1-A1' of FIG. 4. FIG. 6 is an enlarged cross-sectional view of the display element layer EML overlapping the first emission area EA1 in FIG. 5. FIG. 5 illustrates the cross-sectional structure of the first subpixel SP1, the second subpixel SP2, and the third subpixel SP3 in a portion overlapping the display area DDA of the display device 10.

Referring to FIGS. 5 and 6, the transistor layer TFTL may be located on the substrate SUB. The transistor layer TFTL may include a first buffer layer BF1, a bottom metal layer BML provided in plural including bottom metal layers BML, a second buffer layer BF2, a transistor TFT provided in plural including transistors TFT, a gate insulating layer GI, a first insulating layer ILD1, a capacitor electrode CPE provided in plural including capacitor electrodes CPE, a second insulating layer ILD2, a first connection electrode CNE1 provided in plural including first connection electrodes CNE1, a first via layer VIA1, a second connection electrode CNE2 provided in plural including second connection electrodes CNE2, a second via layer VIA2, and a third insulating layer ILD3.

The first buffer layer BF1 may be located on the substrate SUB. The first buffer layer BF1 may include an inorganic layer which can prevent penetration of air or moisture. For example, the first buffer layer BF1 may include a plurality of inorganic layers stacked alternately.

The bottom metal layers BML may be located on the first buffer layer BF1. The bottom metal layers BML may include a conductive metal and may each be, for example, a single layer or a multilayer made of any one or more of molybdenum (Mo), aluminium (Al), chromium (Cr), gold (Au), titanium (Ti), nickel (Ni), neodymium (Nd), copper (Cu), and alloys thereof.

The second buffer layer BF2 may cover the first buffer layer BF1 and the bottom metal layers BML. The second buffer layer BF2 may include an inorganic layer which can prevent penetration of air or moisture. For example, the second buffer layer BF2 may include a plurality of inorganic layers stacked alternately.

The transistors TFT may be disposed on the second buffer layer BF2. The transistors TFT may form pixel circuits. For example, each of the transistors TFT may be a driving transistor or a switching transistor of a pixel circuit (e.g., in a circuit layer).

Each of the transistors TFT may include an active layer ACT, a source electrode SE, a drain electrode DE, and a gate electrode GE.

The active layer ACT may be located on the second buffer layer BF2. The active layer ACT may be overlapped by the gate electrode GE in the third direction DR3 and may be insulated from the gate electrode GE by the gate insulating layer GI. The source electrode SE and the drain electrode DE may be formed (or provided) by making portions of the active layer ACT conductive (e.g., electrically conductive).

The gate insulating layer GI may be located on the active layers ACT. The gate insulating layer GI may cover the active layers ACT and the second buffer layer BF2 and may insulate the active layers ACT from the gate electrodes GE. The gate insulating layer GI may include contact holes through which the first connection electrodes CNE1 pass.

The gate electrodes GE may be located on the gate insulating layer GI. The gate electrodes GE may overlap the active layers ACT with the gate insulating layer GI interposed between them.

The gate electrodes GE may include a conductive metal and may each be, for example, a single layer or a multilayer made of any one or more of molybdenum (Mo), aluminium (Al), chromium (Cr), gold (Au), titanium (Ti), nickel (Ni), neodymium (Nd), copper (Cu), and alloys thereof.

The first insulating layer ILD1 may cover the gate electrodes GE and the gate insulating layer GI. The first insulating layer ILD1 may include contact holes through which the first connection electrodes CNE1 pass. The contact holes of the first insulating layer ILD1 may be connected to the contact holes of the gate insulating layer GI and contact holes of the second insulating layer ILD2.

The capacitor electrodes CPE may be located on the first insulating layer ILD1. The capacitor electrodes CPE may overlap the gate electrodes GE in the third direction DR3. The capacitor electrodes CPE and the gate electrodes GE may form capacitances (e.g., electrical capacitances therebetween).

The second insulating layer ILD2 may cover the capacitor electrodes CPE and the first insulating layer ILD1. The second insulating layer ILD2 may include the contact holes through which the first connection electrodes CNE1 pass. The contact holes of the second insulating layer ILD2 may be connected to the contact holes of the first insulating layer ILD1 and the contact holes of the gate insulating layer GI.

The first connection electrodes CNE1 may be located on the second insulating layer ILD2. The first connection electrodes CNE1 may electrically connect the drain electrodes DE of the transistors TFT to the second connection electrodes CNE2. The first connection electrodes CNE1 may be inserted into (or pass through) the contact holes formed in the first insulating layer ILD1, the second insulating layer ILD2, and the gate insulating layer GI to contact the drain electrodes DE of the transistors TFT. As being in contact, elements may form an interface therebetween.

The first via layer VIA1 may be located on the first connection electrodes CNE1 and the second insulating layer ILD2. The first via layer VIA1 may flatten structures thereunder, that is, planarize an underlying stacked structure to provide a flat upper surface. The first via layer VIA1 may include contact holes through which the second connection electrodes CNE2 pass.

The first via layer VIA1 may include an organic insulating material. For example, the first via layer VIA1 may include acrylic resin, polyimide, polyamide, benzocyclobutene, or phenolic resin.

The second connection electrodes CNE2 may be located on the first via layer VIA1. The second connection electrodes CNE2 may be located in portions overlapping the emission areas EA. The second connection electrodes CNE2 may be inserted into the contact holes formed in the first via layer VIA1 to contact the first connection electrodes CNE1.

The second via layer VIA2 may be located on the first via layer VIA1. The second via layer VIA2 may flatten steps formed by a cross-sectional shape of the second connection electrodes CNE2.

The second via layer VIA2 may include an organic material. For example, the second via layer VIA2 may include acrylic resin, silicone resin, silicone acrylic resin, epoxy resin, polyimide, polyamide, benzocyclobutene, or phenolic resin.

The third insulating layer ILD3 may be located on the second via layer VIA2. The third insulating layer ILD3 may assist in preventing outgas caused by the organic material of the second via layer VIA2 from penetrating into the display element layer EML.

The third insulating layer ILD3 may include an inorganic insulating material. For example, the third insulating layer ILD3 may include at least one of silicon nitride, silicon oxide, and silicon oxynitride.

The display element layer EML may be disposed on the transistor layer TFTL. The display element layer EML may include the bank structure BN, the element insulating layer PDL, light emitting elements ED, an anode planarization layer APL, and element inorganic layers IO.

The bank structure BN may be disposed on the third insulating layer ILD3. The bank structure BN may be located in portions overlapping or adjacent to the emission areas EA or/and the openings OP or/and the anode contact holes ACTH.

The bank structure BN may assist in positioning first through third light emitting elements ED1 through ED3 in portions overlapping the first through third emission areas EA1 through EA3, respectively, and may assist in electrically connecting cathodes CE which are located in the first through third emission areas EA1 through EA3 and spaced apart from each other, to each other.

The bank structure BN may include a first bank layer BN1, a second bank layer BN2, and a third bank layer BN3. The first bank layer BN1, the second bank layer BN2, and the third bank layer BN3 may be sequentially stacked in the third direction DR3. Patterns of the various bank layers may together form a bank of a bank layer.

The first bank layer BN1 may be located on the third insulating layer ILD3. The first bank layer BN1 may cover the third insulating layer ILD3 in portions overlapping or adjacent to the emission areas EA and in a portion overlapping the non-emission area NLA.

The first bank layer BN1 may assist in applying a low potential voltage to the cathodes CE. The first bank layer BN1 may include a conductive metal having etch resistance. For example, the first bank layer BN1 may include titanium (Ti).

The first bank layer BN1 may be penetrated by the anode contact holes ACTH in the portions overlapping the emission areas EA. In other words, a material (or a solid portion) of the first bank layer BN1 may surround the anode contact holes ACTH and may be formed in the form of a single conductive pattern surrounding the anode contact holes ACTH. The pattern of the first bank layer BN1 may be a discrete pattern in the plan view, without being limited thereto.

The second bank layer BN2 may be located on the first bank layer BN1 to contact the first bank layer BN1. The second bank layer BN2 may be penetrated by the anode contact holes ACTH in the portions overlapping the emission areas EA. In other words, the second bank layer BN2 may surround the anode contact holes ACTH.

The second bank layer BN2 may be formed in multiple pieces, and the pieces of the second bank layer BN2 may be spaced apart from each other in the first direction DR1. In other words, the pieces of the second bank layer BN2 may be located in the portions overlapping the first through third emission areas EA1 through EA3, respectively, and may be spaced apart from each other in the form of islands (or discrete patterns).

The second bank layer BN2 may assist in electrically connecting the first bank layer BN1 to the third bank layer BN3. In other words, the second bank layer BN2 may be electrically connected to the first bank layer BN1 and the third bank layer BN3. Accordingly, the second bank layer BN2 located in a portion overlapping or adjacent to the first emission area EA1, the second bank layer BN2 located in a portion overlapping or adjacent to the second emission area EA2, and the second bank layer BN2 located in a portion overlapping or adjacent to the third emission area EA3 may be electrically connected to each other by the first bank layer BN1 extended between the two emission areas.

The second bank layer BN2 may include a metal having high electrical conductivity. For example, the second bank layer BN2 may include aluminium (Al).

The third bank layer BN3 may be located on the second bank layer BN2 to contact the second bank layer BN2. The third bank layer BN3 may be penetrated by the anode contact holes ACTH in the portions overlapping the emission areas EA. In other words, the third bank layer BN3 may surround the anode contact holes ACTH.

The third bank layer BN3 may be formed in multiple pieces, and the pieces of the third bank layer BN3 may be spaced apart from each other in the first direction DR1. In other words, the pieces of the third bank layer BN3 may be located in the portions overlapping or adjacent to the first through third emission areas EA1 through EA3, respectively, and may be spaced apart from each other in the form of islands.

The third bank layer BN3 may include a conductive metal having etch resistance. For example, the third bank layer BN3 may be titanium (Ti).

In an embodiment, the third bank layer BN3 located in the portion overlapping or adjacent to the first emission area EA1, the third bank layer BN3 located in the portion overlapping or adjacent to the second emission area EA2, and the third bank layer BN3 located in the portion overlapping or adjacent to the third emission area EA3 may be electrically connected through the second bank layer BN2 and the first bank layer BN1. Redundant descriptions will be omitted.

The first to third bank layers BN1 to BN3, may collectively define a bank at the non-emission area NLA. The bank layers may together define a bank hole corresponding to a respective emission area, and the bank opening may overlap a respective anode contact hole ACTH. Inner side surfaces (or sidewalls) of the first to third bank layers BN1 to BN3 may define thickness portions of the bank opening along the thickness direction. The bank (e.g., the bank structure BN) together with the bank opening may define a bank layer. The bank at the non-emission area NLA may have a bank recess defined therein, where the first bank layer BN1 which extends across the non-emission area NLA may provide a bottom of the bank recess.

As illustrated in FIG. 6, the second bank layer BN2 may include first side surfaces 2c as an outer surface facing the non-emission area NLA, and the third bank layer BN3 may include tips protruding more than (e.g., further than) the first side surfaces 2c of the second bank layer BN2 in the first direction DR1. Accordingly, the first side surfaces 2c of the second bank layer BN2 and the tips of the third bank layer BN3 may form an undercut, and the bank structure BN has an overhang structure.

In the display device 10 of the embodiment, since the bank structure BN includes the tips, the first light emitting element ED1, the second light emitting element ED2, and the third light emitting element ED3 spaced apart from each other can be formed without using a fine metal mask in a fabrication process. The fabrication process will be described later.

The element insulating layer PDL may include a first element insulating layer PDL1 and a second element insulating layer PDL2.

The first element insulating layer PDL1 may be located on the third bank layer BN3. The first element insulating layer PDL1 may cover the third bank layer BN3 and may overlap the tips of the third bank layer BN3 in the third direction DR3.

The first element insulating layer PDL1 may be penetrated by the anode contact holes ACTH in the portions overlapping the emission areas EA. In other words, the first element insulating layer PDL1 may surround the anode contact holes ACTH.

The first element insulating layer PDL1 may separate and insulate the bank structure BN from anodes AE so that they do not contact each other. Accordingly, the first element insulating layer PDL1 may entirely cover inner side surfaces of the bank structure BN which face the anode contact holes ACTH. Therefore, the first element insulating layer PDL1 can solve a short-circuit defect of the display device 10 due to a contact between the anodes AE and the bank structure BN.

The first element insulating layer PDL1 may include an inorganic insulating material. For example, the first element insulating layer PDL1 may include at least one of silicon nitride, silicon oxide, and silicon oxynitride.

The second element insulating layer PDL2 may be located on the first element insulating layer PDL1. Among the first and second element insulating layers PDL1 and PLD2, the second element insulating layer PDL2 may define the openings OP and expose the anodes AE in portions overlapping the openings OP. In other words, the second element insulating layer PDL2 may surround the openings OP and cover edges of the anodes AE.

The second element insulating layer PDL2 may include an inorganic insulating material. For example, the second element insulating layer PDL2 may include at least one of silicon nitride, silicon oxide, and silicon oxynitride.

The first and second element insulating layers PDL1 and PLD2, may collectively define a pixel defining pattern at the non-emission area NLA. The element insulating layers may together define a pixel opening (e.g., the opening OP) corresponding to a respective emission area, and the pixel opening may overlap a respective anode contact hole ACTH. Inner side surfaces (or sidewalls) of the first and second element insulating layers PDL1 and PLD2 may define thickness portions of the pixel opening along the thickness direction. The pixel defining pattern together with the pixel opening may define a pixel defining layer. The first and second element insulating layers PDL1 and PLD2 may together define a pixel defining layer recess which is open laterally (e.g., along the first direction DR1) toward the respective emission area EA.

The light emitting elements ED of an embodiment may be located on the bank structure BN. The light emitting elements ED may overlap the bank structure BN and the element insulating layer PDL in the third direction DR3. In addition, the light emitting elements ED may overlap the anode contact holes ACTH in the third direction DR3.

The display device 10 of the embodiment may be applied to a high-resolution electronic device. Therefore, a plurality of light emitting elements ED included in the display device 10 may be required to be disposed within a narrow area (e.g., narrow planar area) with an appropriate distance between them. Accordingly, in the display device 10 of the embodiment, the light emitting elements ED may be formed on the bank structure BN so that they can be efficiently disposed within a narrow area.

The light emitting elements ED may include the first light emitting element ED1 disposed in the first emission area EA1, the second light emitting element ED2 disposed in the second emission area EA2, and the third light emitting element ED3 disposed in the third emission area EA3. The first light emitting element ED1, the second light emitting element ED2, and the third light emitting element ED3 may be spaced apart from each other.

The first light emitting element ED1 may include an anode AE, a first light emitting layer EL1, a cathode CE, and an auxiliary electrode AX. The second light emitting element ED2 may include an anode AE, a second light emitting layer EL2, a cathode CE, and an auxiliary electrode AX. The third light emitting element ED3 may include an anode AE, a third light emitting layer EL3, a cathode CE, and an auxiliary electrode AX.

The first light emitting element ED1, the second light emitting element ED2, and the third light emitting element ED3 may emit light of different colors. For example, the first light emitting element ED1 may emit red light, the second light emitting element ED2 may emit green light, and the third light emitting element ED3 may emit blue light. The colors of light emitted from the first light emitting element ED1, the second light emitting element ED2, and the third light emitting element ED3 may be determined by the first light emitting layer EL1, the second light emitting layer EL2, and the third light emitting layer EL3.

In an embodiment, the anode contact holes ACTH may be located in the portions overlapping the emission areas EA. The anode contact holes ACTH may be formed to penetrate the third insulating layer ILD3, the first bank layer BN1, the second bank layer BN2, and the third bank layer BN3. The anode contact hole ACTH hole may include a third insulating layer contact hole defined in the third insulating layer ILD3, together with the bank opening of the bank layer and the pixel opening of the pixel defining layer. The anode contact hole ACTH may expose the second connection electrode CNE2 to outside each of the third insulating layer ILD3 and the bank structure BN.

In the display device 10 of the embodiment, the anode contact holes ACTH may be formed not in a separate space, but to overlap the emission areas EA so that contact areas of the anodes AE at which the anodes AE are electrically connected to the transistor layer TFTL, are integrated within the emission areas EA. Therefore, in the display device 10 of the embodiment, a plurality of emission areas EA can be efficiently disposed within a narrow area.

The anodes AE may be located on the first element insulating layer PDL1. The anodes AE may be located in the portions overlapping the emission areas EA or/and the openings OP or/and the anode contact holes ACTH.

Each of the anodes AE may include a first conductive layer AEa and a second conductive layer AEb. The first conductive layer AEa and the second conductive layer AEb may be sequentially stacked in the third direction DR3.

The first conductive layer AEa may be located on the first element insulating layer PDL1. The first conductive layer AEa may contact and cover the first element insulating layer PDL1 and may extend through the bank opening and the third insulating layer contact hole to contact a second connection electrode CNE2 of the transistor layer TFTL. In other words, in a portion overlapping each anode contact hole ACTH, the first conductive layer AEa may entirely cover exposed portions of the first element insulating layer PDL1 and the third insulating layer ILD3 and may extend to contact a second connection electrode CNE2. Therefore, the first conductive layer AEa may be electrically connected to the second connection electrode CNE2.

The first conductive layer AEa may cover the first element insulating layer PDL1, the third insulating layer ILD3, and the second connection electrode CNE2 with a uniform thickness along the profile formed by the first element insulating layer PDL1, the third insulating layer ILD3, and the second connection electrode CNE2. Here, a thickness is defined perpendicular to respective surfaces of the first element insulating layer PDL1, the third insulating layer ILD3, and the second connection electrode CNE2. Accordingly, the first conductive layer AEa may include a step having the same shape as the structure thereunder. The meaning of the uniform thickness mentioned above may include a process error of about 10% or less.

The first conductive layer AEa may include a transparent conductive oxide (TCO). For example, the first conductive layer AEa may include at least any one of indium-zinc-oxide (IZO) and indium-tin-oxide (ITO).

The second conductive layer AEb may be located on the first conductive layer AEa. The second conductive layer AEb may contact a portion of the first conductive layer AEa. Accordingly, the first conductive layer AEa and the second conductive layer AEb may be electrically connected. The second conductive layer AEb may be exposed to outside the pixel defining layer in a portion overlapping each opening OP. The second conductive layer AEb may contact the first, second or third emitting layer EL1, EL2 or EL3 in the portion overlapping each opening OP. Edges of the second conductive layer AEb which do not overlap each opening OP may be covered by a solid portion of the second element insulating layer PDL2.

The second conductive layer AEb may have a stacked structure of a material layer having a high work function such as indium-tin-oxide (ITO), indium-zinc-oxide (IZO), zinc oxide (ZnO) or indium oxide (In₂O₃) and a reflective material layer such as silver (Ag), magnesium (Mg), aluminium (Al), platinum (Pt), lead (Pb), palladium (Pd), gold (Au), nickel (Ni), neodymium (Nd), iridium (Ir), chromium (Cr), lithium (Li), or a mixture thereof. For example, the second conductive layer AEb may have, but is not limited to, a multilayer structure of ITO/Mg, ITO/MgF, ITO/Ag, or ITO/Ag/ITO.

In a process of fabricating the display device 10, the first conductive layer AEa and the second conductive layer AEb may be formed in different processes. Accordingly, a boundary surface (or interface) may be formed between facing surfaces of the first conductive layer AEa and the second conductive layer AEb. From the boundary surface formed between the facing surfaces of the first conductive layer AEa and the second conductive layer AEb in the display device 10 of the embodiment, it can be seen that the first conductive layer AEa and the second conductive layer AEb are formed in different processes.

The anode planarization layer APL is located between the first conductive layer AEa and the second conductive layer AEb. The anode planarization layer APL may contact the first conductive layer AEa and the second conductive layer AEb. The anode planarization layer APL may be completely surrounded (or enclosed) by the first conductive layer AEa and the second conductive layer AEb in the portion overlapping each anode contact hole ACTH. The first conductive layer AEa may have a recess defined therein, and the anode planarization layer APL may fill the anode recess, without being limited thereto. The second conductive layer AEb may be spaced apart from the first conductive layer AEa in the emission area EA. The second conductive layer AEb may be spaced apart from the first conductive layer AEa by a gap in which the anode planarization layer APL is disposed.

The anode planarization layer APL may flatten a step included in the first conductive layer AEa in the portion overlapping each anode contact hole ACTH. Here, upper surfaces of the anode planarization layer APL and the first conductive layer AEa which are furthest from the transistor layer TFTL, may be coplanar with each other to provide a flat upper surface along which the second conductive layer AEb is extended.

For example, when the display device 10 does not include the anode planarization layer APL, the second conductive layer AEb may include a step corresponding to the recessed shape of the first conductive layer AEa. The step corresponding to the recessed shape of the first conductive layer AEa may include the same meaning as a step corresponding to the shape of each anode contact hole ACTH.

For example, when the second conductive layer AEb includes a step corresponding to the shape of the first conductive layer AEa or the shape of each anode contact hole ACTH, the first, second or third light emitting layer EL1, EL2 or EL3 may be formed to have a thickness below a certain range in a portion overlapping edges of each anode contact hole ACTH. Accordingly, this may cause a reliability defect (e.g., a light emitting layer shadow defect) of the display device 10. Since materials of the first, second or third light emitting layer EL1, EL2 or EL3 are formed on the flat upper surface of the underlying anode AE, a sufficient thickness of the materials may be maintained.

The reliability defect (e.g., the light emitting layer shadow defect) may be a defect in which the luminance of the display device 10 is measured to be low below a certain range level in some portions because materials which form the first through third light emitting layer EL1 through EL3 are formed to have a thickness below a certain range in some portions.

Therefore, the display device 10 of the embodiment may flatten the step included in the first conductive layer AEa by including the anode planarization layer APL in the portion overlapping each anode contact hole ACTH. Accordingly, the second conductive layer AEb may have a relatively flat shape, causing the first through third light emitting layers EL1 through EL3 to be formed to a uniform thickness. Therefore, the reliability defect (e.g., the light emitting layer shadow defect) of the display device 10 can be solved. Here, the anode AE may include not only the conductive layers, but also the anode planarization layer APL.

The anode planarization layer APL includes an organic material. For example, the anode planarization layer APL may include acrylic resin, silicone resin, silicone acrylic resin, epoxy resin, polyimide, polyamide, benzocyclobutene, or phenolic resin. That is, the anode AE may include not only a conductive material, but also an organic material disposed therebetween.

The first through third light emitting layers EL1 through EL3 may be located on the anodes AE. The first through third light emitting layers EL1 through EL3 may be located in the portions overlapping the emission areas EA and the non-emission area NLA. The first through third light emitting layers EL1 through EL3 may overlap the bank structure BN and the element insulating layer PDL in the third direction DR3.

The first through third light emitting layers EL1 through EL3 may contact the anodes AE in the portions overlapping the openings OP and may cover the entire second element insulating layer PDL2 in the portion overlapping the non-emission area NLA.

The first through third light emitting layers EL1 through EL3 may be organic light emitting layers made of (or including) an organic material. The first through third light emitting layers EL1 through EL3 may include any commonly used material.

The first light emitting layer EL1, the second light emitting layer EL2, and the third light emitting layer EL3 may emit light of different colors. For example, the first light emitting layer EL1 may emit red light, the second light emitting layer EL2 may emit green light, and the third light emitting layer EL3 may emit blue light, but embodiments are not limited thereto.

The first light emitting layer EL1 may be located in the portion overlapping the first emission area EA1, the second light emitting layer EL2 may be located in the portion overlapping the second emission area EA2, and the third light emitting layer EL3 may be located in the portion overlapping the third emission area EA3. The first light emitting layer EL1, the second light emitting layer EL2, and the third light emitting layer EL3 may be spaced apart from each other in the portion overlapping the non-emission area NLA.

In the display device 10 of the embodiment, since the third bank layer BN3 includes the tips, the first light emitting layer EL1, the second light emitting layer EL2, and the third light emitting layer EL3 spaced apart from each other can be formed without using a fine metal mask in the process of fabricating the display device 10. The fabrication process will be described later.

The cathodes CE may be located on the first through third light emitting layers EL1 through EL3. The cathodes CE may be located in the portions overlapping the emission areas EA and the non-emission area NLA. The cathodes CE may entirely cover the first through third light emitting layers EL1 through EL3.

The cathodes CE may contact the bank structure BN and thus may be electrically connected to the bank structure BN. Specifically, the cathodes CE may contact the tips of the third bank layer BN3.

The cathodes CE may include a transparent conductive material to transmit light generated from the first through third light emitting layers EL1 through EL3. For example, the cathodes CE may include a material layer having a small work function such as Li, Ca, LiF/Ca, LiF/Al, Al, Mg, Ag, Pt, Pd, Ni, Au Nd, Ir, Cr, BaF, Ba, or a compound or mixture thereof (e.g., a mixture of Ag and Mg). The cathodes CE may further include a transparent metal oxide layer disposed on the material layer having a small work function.

In an embodiment, the cathode CE located in the portion overlapping the first emission area EA1, the cathode CE located in the portion overlapping the second emission area EA2, and the cathode CE located in the portion overlapping the third emission area EA3 may be spaced apart from each other. The cathodes CE located in the first through third emission areas EA1 through EA3, respectively, and spaced apart from each other may be electrically connected through the bank structure BN. Specifically, the cathodes CE located in the first through third emission areas EA1 through EA3, respectively, and spaced apart from each other may contact the third bank layer BN3 spaced apart from the first through third emission areas EA1 through EA3 and may be electrically connected to each other through the second bank layer BN2 and the first bank layer BN1 electrically connected to the third bank layer BN3.

In the display device 10 of the embodiment, since the third bank layer BN3 includes the tips, the cathodes CE located in the first through third emission areas EA1 through EA3, respectively, and spaced apart from each other can be formed without using a fine metal mask. The fabrication process will be described later.

The auxiliary electrodes AX may be located on the cathodes CE. The auxiliary electrodes AX may be located in the portions overlapping the emission areas EA and the non-emission area NLA. The auxiliary electrodes AX may entirely cover the cathodes CE. The auxiliary electrodes AX may assist in electrically connecting the cathodes CE to the bank structure BN. Here, the auxiliary electrodes AX may be considered a part of a cathode layer, without being limited thereto.

The auxiliary electrodes AX may include a transparent conductive oxide (TCO). For example, the auxiliary electrodes AX may include at least any one of indium-zinc-oxide (IZO) and indium-tin-oxide (ITO).

In an embodiment, the auxiliary electrode AX located in the portion overlapping the first emission area EA1, the auxiliary electrode AX located in the portion overlapping the second emission area EA2, and the auxiliary electrode AX located in the portion overlapping the third emission area EA3 may be spaced apart from each other. The auxiliary electrodes AX located in the first through third emission areas EA1 through EA3, respectively, and spaced apart from each other may be electrically connected to each other through the bank structure BN. Specifically, the auxiliary electrodes AX located in the first through third emission areas EA1 through EA3, respectively, and spaced apart from each other may contact the third bank layer BN3 spaced apart from the first through third emission areas EA1 through EA3 and may be electrically connected to each other through the second bank layer BN2 and the first bank layer BN1 electrically connected to the third bank layer BN3.

The auxiliary electrodes AX may be spaced apart from the first bank layer BN1 in the third direction DR3 in the portion overlapping the non-emission area NLA.

The element inorganic layers IO may be located on the light emitting elements ED. The element inorganic layers IO may completely cover the light emitting elements ED and prevent oxygen or moisture from penetrating into the light emitting elements ED.

The element inorganic layers IO may include an inorganic insulating material. For example, the element inorganic layers IO may include any one of silicon nitride, silicon oxide, and silicon oxynitride.

The element inorganic layers IO may include a first element inorganic layer IO1, a second element inorganic layer IO2, and a third element inorganic layer IO3. The first element inorganic layer IO1 may be disposed on the first light emitting element ED1 in the first emission area EA1, the second element inorganic layer IO2 may be disposed on the second light emitting element ED2 in the second emission area EA2, and the third element inorganic layer IO3 may be located on the third light emitting element ED3 in the third emission area EA3. The first element inorganic layer IO1, the second element inorganic layer IO2, and the third element inorganic layer IO3 may be spaced apart from each other in the portion overlapping the non-emission area NLA.

In the drawings, the first element inorganic layer IO1, the second element inorganic layer IO2, and the third element inorganic layer IO3 appear to be formed in the same layer. However, in the process of fabricating the display device 10, the first element inorganic layer IO1 may be formed after the first light emitting element ED1 is formed, the second element inorganic layer IO2 may be formed after the second light emitting element ED2 is formed, and the third element inorganic layer IO3 may be formed after the third light emitting element ED3 is formed. The fabrication process will be described later.

In an embodiment, layers of the anode AE through the element inorganic layer IO, inclusive, at a respective emission area, may define a light emission structure.

The thin-film encapsulation layer TFEL may be located on the display element layer EML. The thin-film encapsulation layer TFEL may include an organic encapsulation layer TFE1 and an inorganic encapsulation layer TFE3.

The organic encapsulation layer TFE1 of an embodiment may be located on the element inorganic layers IO. For example, the organic encapsulation layer TFE1 may entirely contact and cover the first element inorganic layer IO1, the second element inorganic layer IO2, and the third element inorganic layer IO3.

The organic encapsulation layer TFE1 may flatten steps formed according to the profiles of structures thereunder. The organic encapsulation layer TFE1 may fill portions between the auxiliary electrodes AX and the first bank layer BN1 in the portion overlapping the non-emission area NLA. Here, the organic encapsulation layer TFE1 may fill an empty space at the recess in the bank.

The organic encapsulation layer TFE1 may include a polymer-based material. For example, the organic encapsulation layer TFE1 may include acrylic resin, silicone resin, epoxy resin, silicone acrylic resin, polyimide, or polyethylene.

The inorganic encapsulation layer TFE3 may be located on the organic encapsulation layer TFE1. The inorganic encapsulation layer TFE3 may protect structures thereunder from penetration of moisture and oxygen. The inorganic encapsulation layer TFE3 can be omitted depending on embodiments.

The inorganic encapsulation layer TFE3 may include an inorganic insulating material. For example, the inorganic encapsulation layer TFE3 may include any one of silicon nitride, silicon oxide, and silicon oxynitride.

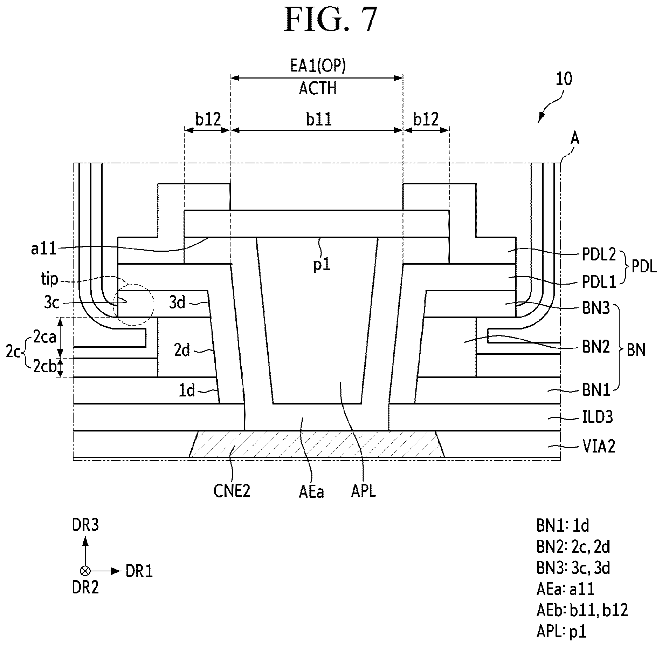

FIG. 7 is an enlarged cross-sectional view of area 'A' in FIG. 6.

Referring to FIG. 7 in addition to FIGS. 1 through 6, the bank structure BN may have an asymmetrical cross-sectional structure in a portion facing an anode contact hole ACTH and a portion opposite the above portion.

For example, in the portion facing the anode contact hole ACTH, a second side surface 1d of the first bank layer BN1, a second side surface 2d of the second bank layer BN2, and a second side surface 3d of the third bank layer BN3 may be located on the same line. Being located on the same line may have the same meaning as being aligned or extended, such as being coplanar. Here, these three inner side surfaces may be coplanar with each other and together form an inner sidewall of the bank which defines the bank opening. The three inner side surfaces may define respective thickness portions of the bank opening.

The second side surface 1d of the first bank layer BN1, the second side surface 2d of the second bank layer BN2, and the second side surface 3d of the third bank layer BN3 may be located on the same line as the first bank layer BN1, the second bank layer BN2, and the third bank layer BN3 are removed by the same etching process in the process of fabricating the display device 10. The fabrication process will be described later.

For example, in the portion opposite the portion facing the anode contact hole ACTH, a first side surface 3c as an outer sidewall of the third bank layer BN3 may protrude more than a first side surface 2c as an outer sidewall of the second bank layer BN2 in the first direction DR1. That is, the third bank layer BN3 may include a tip protruding more than the first side surface 2c of the second bank layer BN2 in the first direction DR1. Redundant descriptions will be omitted.

In an embodiment, a cathode CE may be located on the first side surface 3c of the third bank layer BN3 to contact the first side surface 3c. In addition, an auxiliary electrode AX may contact the tip of the third bank layer BN3 and may extend to contact the second bank layer BN2.

In an embodiment, the first side surface 2c of the second bank layer BN2 may include a first portion 2ca as a first sidewall portion and a second portion 2cb as a second sidewall portion depending on a portion which it contacts. The first portion 2ca may be a portion which contacts the auxiliary electrode AX, and the second portion 2cb may be a portion which contacts the organic encapsulation layer TFE1.

In an embodiment, a contact area between the auxiliary electrode AX and the bank structure BN may be larger than a contact area between the cathode CE and the bank structure BN. Referring to FIGS. 6 and 7, the contact area may be defined along the third direction DR3 and the second direction DR2. Dimensions along the third direction DR3 in FIGS. 6 and 7 may represent the relative contact areas.

In an embodiment, the first bank layer BN1, the second bank layer BN2, and the third bank layer BN3 may be spaced apart from the anode planarization layer APL and may surround the anode planarization layer APL.

The first element insulating layer PDL1 may entirely cover the second side surface 1d of the first bank layer BN1, the second side surface 2d of the second bank layer BN2, and the second side surface 3d of the third bank layer BN3.

The second element insulating layer PDL2 may cover edges (or end surfaces) of the first conductive layer AEa and the second conductive layer AEb of an anode AE and may extend to contact the first element insulating layer PDL1.

The second conductive layer AEb of the anode AE may include a first portion b11 and a second portion b12 depending on a portion which it overlaps. The first portion b11 may be a portion which contacts or overlaps the anode planarization layer APL, and the second portion b12 may be a portion which contacts or overlaps the first conductive layer AEa. The first portion b11 may be a middle portion of the second conductive layer AEb, and the second portion b12 may be an edge portion of the second conductive layer AEb.

In an embodiment, the anode planarization layer APL may include a first surface p1 facing the second conductive layer AEb. In the process of fabricating the display device 10 of the embodiment, the anode planarization layer APL may be formed by performing a chemical mechanical polishing (CMP) process. Therefore, the anode planarization layer APL may include the first surface p1. The fabrication process will be described later.

In an embodiment, the first surface p1 of the anode planarization layer APL may extend with a first surface a11 of the first conductive layer AEa in the first direction DR1, such as to be coplanar with each other. The first surface a11 of the first conductive layer AEa may be a surface facing the second conductive layer AEb. For example, the first surface p1 of the anode planarization layer APL included in the display device 10 may be a flat surface without a bend.

The first surface p1 of the anode planarization layer APL may have various shapes depending on process conditions under which the CMP process is performed.

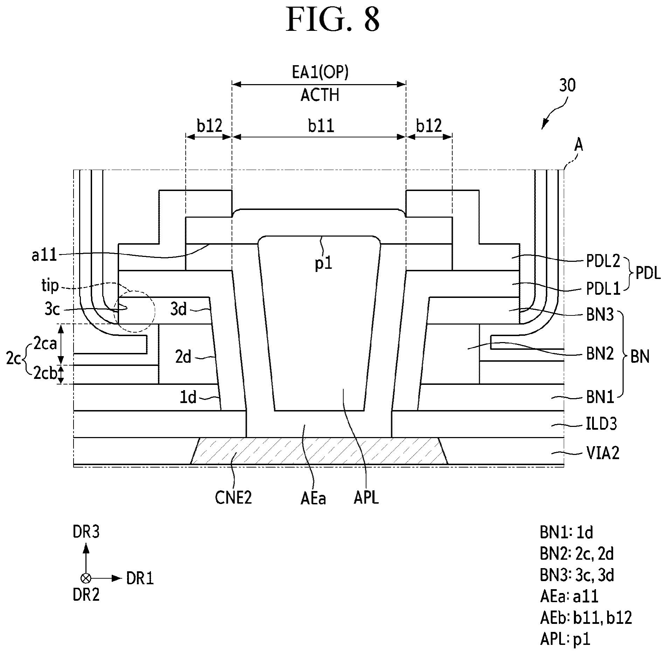

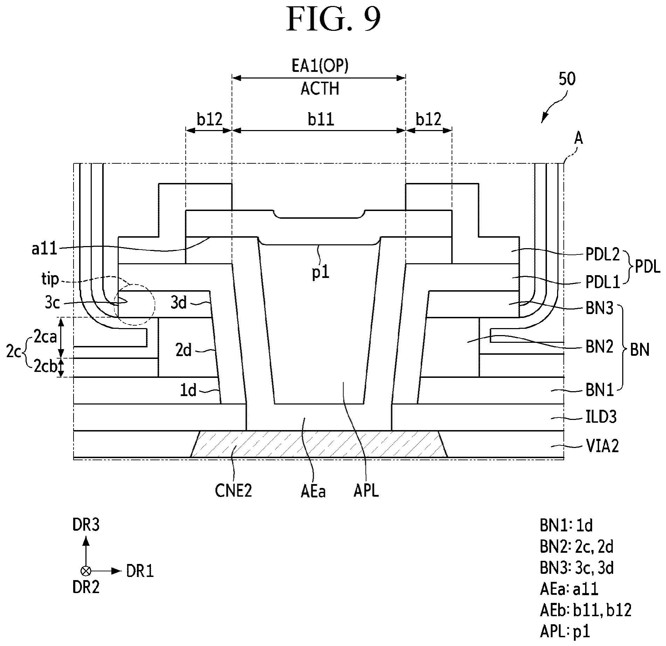

FIGS. 8 and 9 are enlarged cross-sectional views of embodiments of area 'A' in FIG. 6.

Referring to FIG. 8 in addition to FIGS. 1 through 7, a first surface p1 of an anode planarization layer APL included in a display device 30 may have a different cross-sectional shape from the first surface p1 of the anode planarization layer APL included in the display device 10. Therefore, common descriptions of the display device 10 and the display device 30 will be omitted, and differences will be described below.

The first surface p1 of the anode planarization layer APL included in the display device 30 may be curved. For example, the first surface p1 of the anode planarization layer APL included in the display device 30 may be convex in a direction toward one side in the third direction DR3, that is, toward a second conductive layer AEb. In other words, the first surface p1 of the anode planarization layer APL included in the display device 30 may have a convex portion protruding more than a first surface a11 of a first conductive layer AEa in the direction toward one side in the third direction DR3.

In a process of fabricating the display device 30, the first surface p1 of the anode planarization layer APL may be formed through a CMP process. However, the CMP process performed in the process of fabricating the display device 30 may have different process conditions from the CMP process performed in the process of fabricating the display device 10. For example, the process conditions may include at least any one of abrasive particles, an oxidizer, a polymer compound, an inhibitor, a chelating agent, a pH regulator such as acid or alkali, rotation speed of a pad, pressure of a head, and a process time.

The first surface p1 of the anode planarization layer APL included in the display device 30 may have a different polishing speed and planarization degree from the first surface p1 of the anode planarization layer APL included in the display device 10 according to the above-described process conditions of the CMP process and thus may be convex toward one side in the third direction DR3.

In the drawing, the second conductive layer AEb of an anode AE included in the display device 30 is convex toward one side in the third direction DR3 because it covers the anode planarization layer APL included in the display device 30 along the shape of the anode planarization APL, but the present specification is not limited thereto. According to an embodiment, the second conductive layer AEb of the anode AE included in the display device 30 may also have a flat surface even though the anode planarization layer APL has a protruded portion.

Since the display device 30 includes the anode planarization layer APL in a portion overlapping an anode contact hole ACTH, a step included in the first conductive layer AEa can be flattened. Accordingly, the second conductive layer AEb may have a relatively flat shape, causing a first, second or third light emitting layer EL1, EL2 or EL3 to be formed to a uniform thickness. Therefore, the display device 30 can solve a reliability defect (e.g., a light emitting layer shadow defect). Other redundant descriptions will be omitted.

Referring to FIG. 9 in addition to FIGS. 1 through 8, a first surface p1 of an anode planarization layer APL included in a display device 50 may have a different shape from the first surface p1 of the anode planarization layer APL included in the display device 10. Therefore, common descriptions of the display device 10 and the display device 50 will be omitted, and differences will be described below.

The first surface p1 of the anode planarization layer APL included in the display device 50 may be curved. For example, the first surface p1 of the anode planarization layer APL included in the display device 50 may be concave in a direction toward the other side in the third direction DR3, that is, toward a second connection electrode CNE2. In other words, the first surface p1 of the anode planarization layer APL included in the display device 50 may have a concave portion protruding more than a first surface a11 of a first conductive layer AEa in the direction toward the other side in the third direction DR3.

The first surface p1 of the anode planarization layer APL included in the display device 50 may have a different polishing speed and planarization degree from the first surface p1 of the anode planarization layer APL included in the display device 10 according to the above-described process conditions of the CMP process and thus may be concave toward the other side in the third direction DR3.

In the drawing, a second conductive layer AEb of an anode AE included in the display device 50 is concave toward the other side in the third direction DR3 because it covers the anode planarization layer APL included in the display device 50 along the shape of the anode planarization APL, but the present specification is not limited thereto.

According to an embodiment, the second conductive layer AEb of the anode AE included in the display device 50 may also have a flat surface even though the anode planarization layer APL has a recessed portion.

Since the display device 50 includes the anode planarization layer APL in a portion overlapping an anode contact hole ACTH, a step included in the first conductive layer AEa can be flattened. Accordingly, the second conductive layer AEb may have a relatively flat shape, causing a first, second or third light emitting layer EL1, EL2 or EL3 to be formed to a uniform thickness. Therefore, the display device 50 can solve a reliability defect (e.g., a light emitting layer shadow defect). Other redundant descriptions will be omitted.

While the emission area EA, the opening OP and the anode contact hole ACTH overlap each other at a common planar area, respective boundaries of the emission area EA, the opening OP and the anode contact hole ACTH may be defined by inner sidewalls of different layers. In an embodiment, for example, the emission area EA may be defined by a maximum distance between inner sidewalls of the pixel defining layer or may be defined by outer edges of a light emitting layer. The opening OP may be defined by a maximum distance between inner sidewalls of the pixel defining layer. The anode contact hole ACTH may be defined by inner sidewalls of the third insulating layer ILD3, since the anode electrode AE has a contact area with the second connection electrode CNE2 between such inner sidewalls.

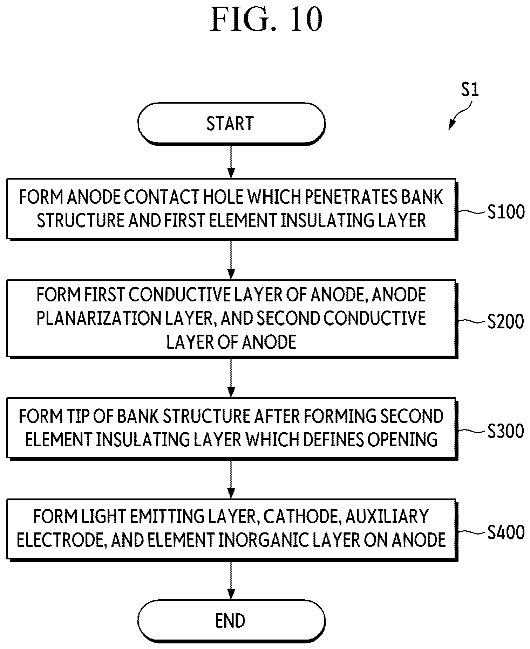

FIG. 10 is a flowchart illustrating a method S1 of fabricating (or providing) the display element layer EML of FIG. 5.

Referring to FIG. 10, the method S1 of fabricating the display element layer EML included in the display device 10 according to the embodiment may include forming (or providing) at an emission area EA, an anode contact hole ACTH which penetrates a bank structure BN and a first element insulating layer PDL1 as a lower layer of the pixel defining layer (operation S100), forming (or providing) a first conductive layer AEa of an anode AE, an anode planarization layer APL and a second conductive layer AEb of the anode AE, at the emission area EA (operation S200), forming a tip of the bank structure BN after forming a second element insulating layer PDL2 which defines an opening (operation S300), and forming a light emitting layer EL, a cathode CE, an auxiliary electrode AX and an element inorganic layer IO on the anode AE (operation S400).

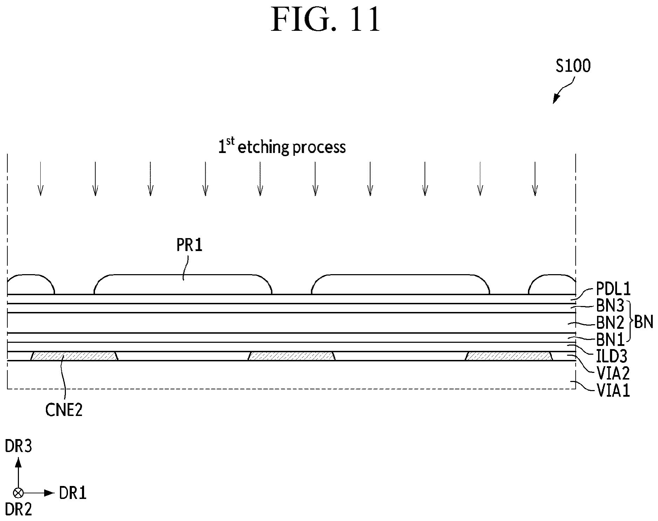

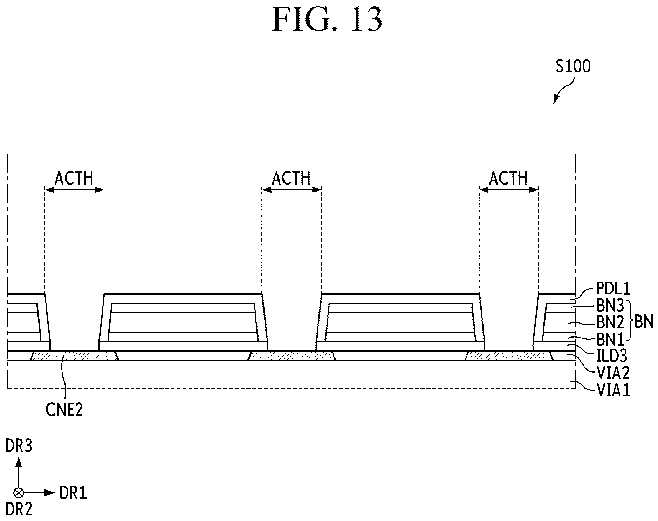

FIGS. 11 through 13 are cross-sectional views illustrating operation S100 of FIG. 10.

The forming of a thickness portion of the anode contact hole ACTH which penetrates the bank structure BN and the first element insulating layer PDL1, at the emission area EA, (operation S100) will be described with reference to FIGS. 11 through 13.

First, a plurality of second connection electrodes CNE2 are formed on a first via layer VIA1. A second via layer VIA2, a third insulating layer ILD3 and a bank structure BN are formed on the entire surfaces of the first via layer VIA1 and the second connection electrodes CNE2. The bank structure BN may include a first bank layer BN1, a second bank layer BN2, and a third bank layer BN3 stacked sequentially. Each of the layers ILD3, BN1, BN2, BN3 and PDL1 shown in FIG. 11 may be considered a preliminary layer of the layers, respectively.

In the current process, the second bank layer BN2 and the third bank layer BN3 may include different materials from each other. For example, the third bank layer BN3 may include a material having a higher etch resistance than that of the second bank layer BN2. Redundant descriptions will be omitted.

Although not illustrated in the drawings, a transistor layer TFTL including the first via layer VIA1 and the second via layer VIA2 may be located on a substrate SUB, and the detailed structure of the transistor layer TFTL is the same as that illustrated in FIG. 5.

Next, photoresists PR1 (as a first photoresist) are formed on the third bank layer BN3, and a first etching process is performed. In the current process, a plurality of photoresists PR1 may be formed and may be located in a portion not overlapping the second connection electrodes CNE2. That is, the first photoresists may be adjacent to or between the second connection electrodes CNE2, in a direction along the transistor layer TFTL. Such locations of the first photoresists may overlap or correspond to the non-emission area NLA.

In the current process, the first etching process may be performed as a dry etching process. For example, the dry etching process may be performed through a reactive ion etching (RIE) process using a reaction gas such as CHF₃, CH₃F, CH₂F₂, CHF₆, CF₄, C₂F₆ or C₃F₆ and a sputtering gas such as Ar or O₂/Ar. In this case, an inductively coupled plasma (ICP) source or a capacitively coupled plasma (CCP) source may be used as a plasma source.

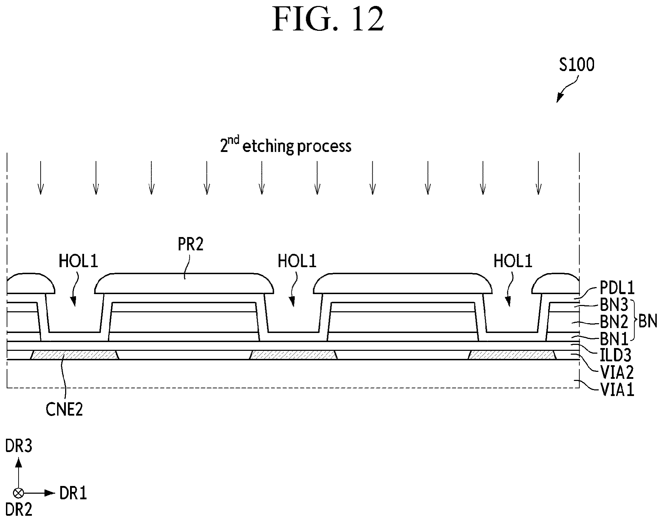

As illustrated in FIG. 12, a thickness of the bank structure BN not overlapped by the photoresists PR1 (e.g., exposed to outside the first photoresists) may all be removed at once to form holes HOL1 as first preliminary holes. Such holes HOL1 may be preliminary bank openings. Side surfaces of the first bank layer BN1, side surfaces of the second bank layer BN2, and side surfaces of the third bank layer BN3 which face the holes HOL1 may be located on the same line. As being on a same line, the side surfaces may be coplanar with each other to provide an inner sidewall of the bank structure BN which defines the bank opening at the emission area EA.

In the current process, the third insulating layer ILD3 may be exposed to outside the bank structure BN, in portions overlapping the holes HOL1.

Although not illustrated in the drawings, the photoresists PR1 may be removed through an ashing process. Removal of the first photoresists exposes an upper surface of the preliminary first element insulating layer.

Next, a first element insulating layer PDL1 is formed on the bank structure BN, such as by patterning the preliminary first element insulating layer shown in FIGS. 11 and 12. The first element insulating layer PDL1 in a preliminary form may be formed on the entire surface of the bank structure BN and may entirely cover the side surfaces of the first bank layer BN1, the side surfaces of the second bank layer BN2 and the side surfaces of the third bank layer BN3 which face the holes HOL1. In addition, the first element insulating layer PDL1 in the preliminary form may extend to cover the third insulating layer ILD3 in the portions overlapping the holes HOL1. Here, the preliminary first element insulating layer may have a recessed structure where recesses are provided overlapping the second connection electrodes CNE2.

In the current process, the first element insulating layer PDL1 in the preliminary form may be formed through a layer forming process (e.g., a deposition process) for forming at least one of the inorganic materials described above.

Next, photoresists PR2 as second photoresists are formed on the first element insulating layer PDL1 in the preliminary form, and a second etching process is performed. A plurality of photoresists PR2 may be formed and may be located in a portion not overlapping the holes HOL1. For example, the second etching process may be performed as a dry etching process. Redundant descriptions will be omitted.

In the current process, thickness portions the first element insulating layer PDL1 and the third insulating layer ILD3 as preliminary forms thereof which are not overlapped by the photoresists PR2 may all be removed at once. As a result, anode contact holes ACTH may be formed, and the second connection electrodes CNE2 may be exposed to outside the third insulating layer ILD3 in portions overlapping the anode contact holes ACTH. Here, a dimension of the anode contact holes ACTH may be a minimum distance between sidewalls of the etched layers ILD3 or PDL1. In an embodiment, a boundary of an anode contact hole ACTH may be defined by a sidewall of the third insulating layer ILD3 which is etched.

Each of the anode contact holes ACTH may overlap an emission area EA. The first element insulating layer PDL1 which is etched may provide a preliminary opening corresponding to the opening OP (e.g., the pixel opening of the pixel defining layer).

Although not illustrated in the drawings, the photoresists PR2 may be removed through an ashing process.

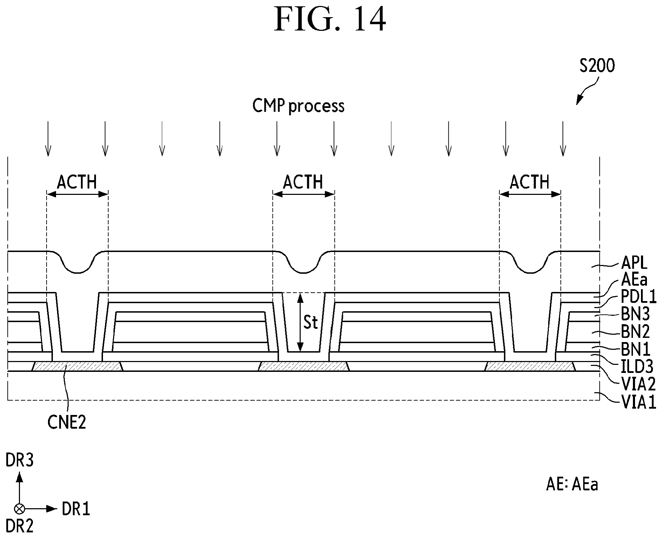

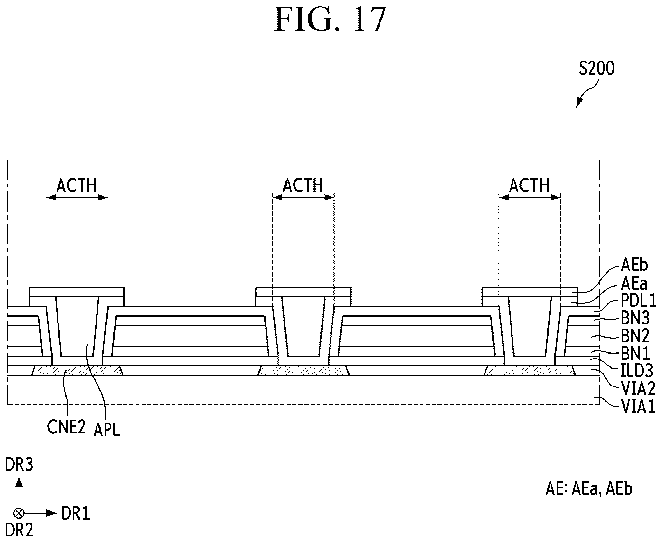

FIGS. 14 through 17 are cross-sectional views illustrating operation S200 of FIG. 10.

The forming of the first conductive layer AEa of the anode AE, the anode planarization layer APL and the second conductive layer of the anode AEb within the anode contact hole ACTH (operation S200) will be described with reference to FIGS. 14 through 17.

First, a preliminary form of a first conductive layer AEa of an anode AE is formed on the first element insulating layer PDL1.

In the current process, the first conductive layer AEa in the preliminary form may be formed through a layer forming process (e.g., sputtering) for forming at least one of the metal materials described above.

In the current process, the first conductive layer AEa in the preliminary form may entirely contact and cover the second connection electrodes CNE2 exposed in the portions overlapping the anode contact holes ACTH and may extend to cover the first element insulating layer PDL1. In directions perpendicular to outer surfaces of the bank structure BN, the first conductive layer AEa may be separated from the bank structure BN by the first element insulating layer PDL1.

Next, a preliminary form of an anode planarization layer APL is formed on the first conductive layer AEa.

In the current process, the anode planarization layer APL in the preliminary form may be formed through a layer forming process (e.g., sputtering) for forming at least one of the metal materials described above and may be formed to a thickness which flattens a step St formed by the first conductive layer AEa in the portions overlapping the anode contact holes ACTH.

Next, a CMP process is performed. For example, the CMP process refers to a process of planarizing an irregular or uneven surface by polishing the surface using chemical/mechanical elements. For example, in the current process, the CMP process may be performed as an organic layer CMP process. The polishing speed and planarization degree of the current process may be controlled according to process conditions (e.g., abrasive particles, an oxidizer, a polymer compound, an inhibitor, a chelating agent, a pH regulator such as acid or alkali, rotation speed of a pad, pressure of a head, and process time).

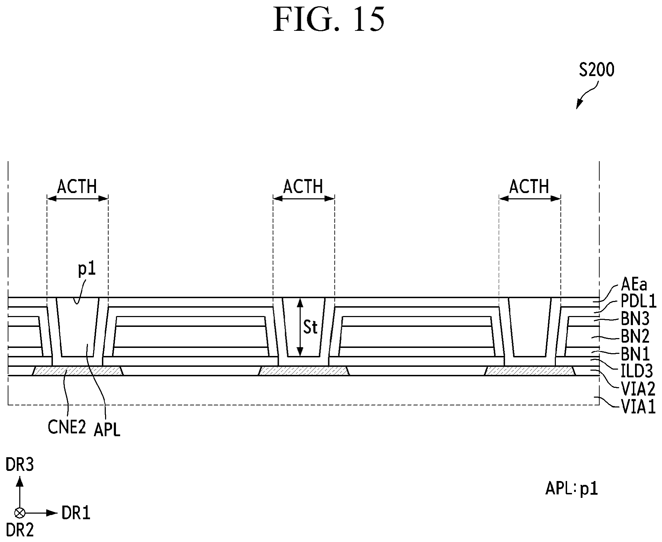

As illustrated in FIG. 15, in the current process, a thickness portion of the anode planarization layer APL which protrudes further than an upper surface of the first conductive layer AEa may be polished and removed, and the anode planarization layer APL which is polished may have a first surface p1 in the portions overlapping the anode contact holes ACTH.

As illustrated and described in FIGS. 7 through 9, the first surface p1 of the anode planarization layer APL may have various shapes depending on the conditions under which the process is performed. Redundant descriptions will be omitted.

Through the current process, the anode planarization layer APL may flatten or planarize the step St formed by the first conductive layer AEa in the portions overlapping the anode contact holes ACTH.

Through the current process, the anode planarization layer APL may be formed in multiple pieces or patterns, and the pieces of the anode planarization layer APL may be spaced apart from each other along the transistor layer TFTL. The anode planarization layer APL may not be located in a portion not overlapping the anode contact holes ACTH. That is, the anode planarization layer may be excluded from areas adjacent to the anode contact holes ACTH.

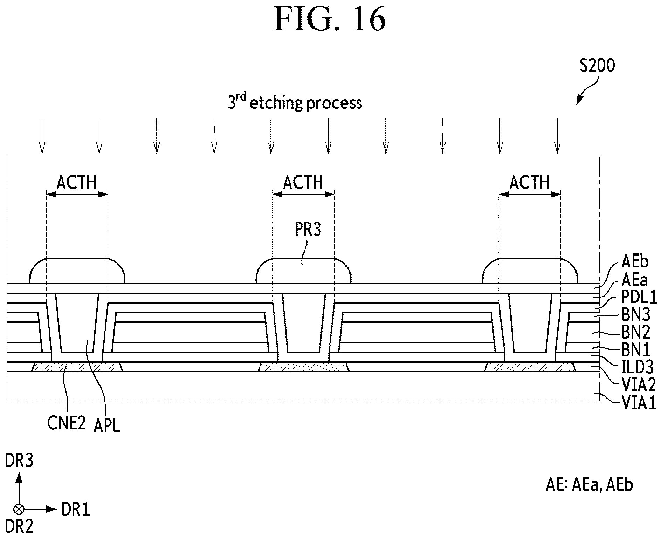

Next, as illustrated in FIG. 16, a preliminary form of a second conductive layer AEb of the anode AE is formed on the first conductive layer AEa and the anode planarization layer APL. The second conductive layer AEb in the preliminary form may be formed on the entire surfaces of the first conductive layer AEa and the anode planarization layer APL and may completely cover the first conductive layer AEa and the anode planarization layer APL.

In the current process, the second conductive layer AEb in the preliminary form may be formed through a layer forming process (e.g., sputtering) for forming at least one of the metal materials described above.

In an embodiment, providing of the anode AE may include providing the anode planarization layer APL extended out of the recess in the first conductive layer AEa to define an extended portion of the anode planarization layer APL, removing the extended portion by chemical mechanical polishing to provide a polished upper surface (e.g., the first surface p1) of the anode planarization layer APL which overlaps the anode contact hole, and contacting the second conductive layer AEb with the polished upper surface of the anode planarization layer APL.

Next, photoresists PR3 as third photoresists are formed on the second conductive layer AEb, and a third etching process is performed. In the current process, a plurality of photoresists PR3 may be formed and may be located in the portions overlapping the anode contact holes ACTH. For example, the third etching process may be performed through at least any one of a dry etching process and a wet etching process.

For example, the wet etching process may be performed using a liquid chemical solution such as a diluted hydrofluoric acid solution, a nitric acid solution, a tetramethylammonium hydroxide solution, or a potassium hydroxide solution.

Through the current process, thickness portions of the first conductive layer AEa and the second conductive layer AEb of the anode AE not overlapped by the photoresists PR3 may be removed, and thus the first conductive layer AEa and the second conductive layer AEb of the anode AE may be patterned.

In the current process, the anode planarization layer APL may be completely surrounded by the first conductive layer AEa and the second conductive layer AEb. Here, upper surfaces of the first element insulating layer PDL1 may be exposed to outside the anodes AE.

Although not illustrated in the drawings, the photoresists PR3 may be removed through an ashing process.

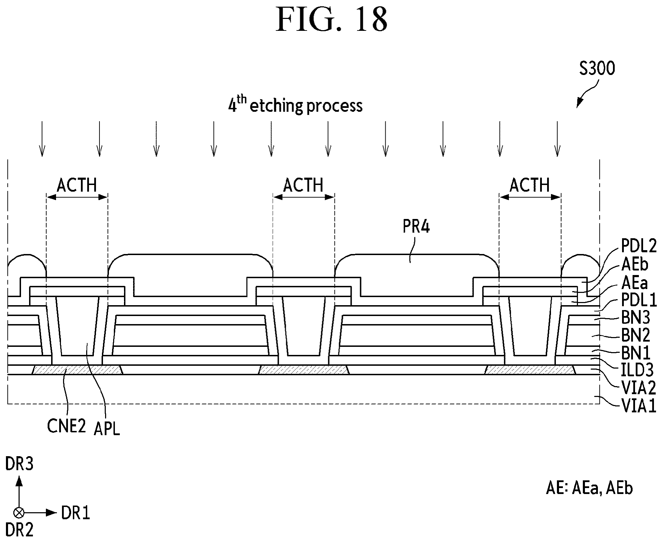

FIGS. 18 through 21 are cross-sectional views illustrating operation S300 of FIG. 10.

The forming of the tip of the bank structure after the forming of the second element insulating layer PDL2 which defines the opening OP at the emission area EA (operation S300) will be described with reference to FIGS. 18 through 21.

First, after a preliminary form of a second element insulating layer PDL2 is formed on anodes AE and the first element insulating layer PDL1, photoresists PR4 as fourth photoresists are formed on the second element insulating layer PDL2, and a fourth etching process is performed. In the current process, a plurality of photoresists PR4 may be formed and may be located in the portion not overlapping the anode contact holes ACTH, that is between emission areas EA adjacent to each other and adjacent to the anode contact holes ACTH. For example, the fourth etching process may be performed as a dry etching process. Redundant descriptions will be omitted.

In the current process, a thickness portion of the second element insulating layer PDL2 not overlapped by the photoresists PR4 may be removed to form openings OP in the pixel defining layer which overlap the bank openings and the anode contact holes ACTH. In other words, the openings OP may be defined by inner sidewalls of the second element insulating layer PDL2, and a solid portion of the second element insulating layer PDL2 may surround the openings OP. In portions overlapping the openings OP, the second conductive layer AEb of each anode AE may be exposed to outside the pixel defining layer.

In the drawings, a width of each anode contact hole ACTH and a width of each opening OP in the first direction DR1 are equal. However, the present specification is not limited thereto. The anode contact holes ACTH and the openings OP may overlap in the third direction DR3, but the width of each anode contact hole ACTH and the width of each opening OP may also be different from each other, such as owing to which sidewalls define the respective contact hole or opening.

Although not illustrated in the drawings, the photoresists PR4 may be removed through an ashing process.

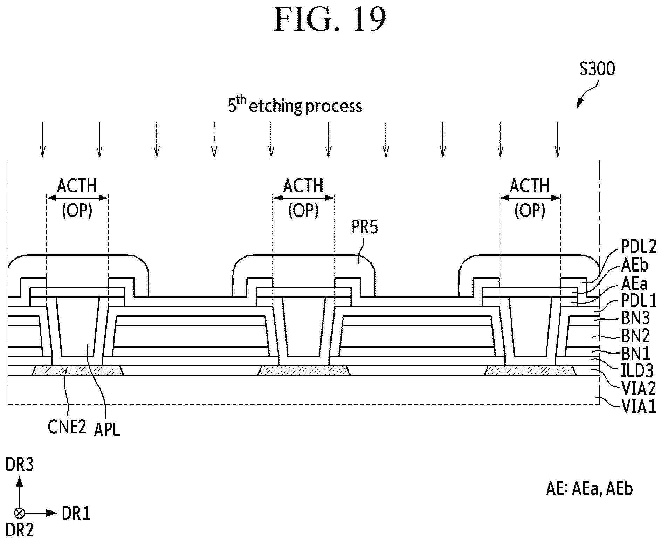

As illustrated in FIG. 19, photoresists PR5 as fifth photoresists are formed on the anodes AE and the second element insulating layer PDL2 which has the openings OP defined therein, and a fifth etching process is performed. In the current process, a plurality of photoresists PR5 may be formed to overlap and fill the openings OP and may be located in the portions overlapping the anode contact holes ACTH. For example, the fifth etching process may be performed as a dry etching process. Redundant descriptions will be omitted.

In the current process, thickness portions of the second element insulating layer PDL2, the first element insulating layer PDL1, the second bank layer BN2, and the third bank layer BN3 not overlapped by the photoresists PR5 may all be removed at once to form a hole HOL2. The hole HOL2 as a second preliminary hole may be formed in the portion not overlapping the anode contact holes ACTH, and side surfaces of the second element insulating layer PDL2, side surfaces of the first element insulating layer PDL1, side surfaces of the second bank layer BN2 and side surfaces of the third bank layer BN3 which face the hole HOL2 may be located on the same line, such as being coplanar with each other. In other words, in the current process, the second element insulating layer PDL2, the first element insulating layer PDL1, the second bank layer BN2, and the third bank layer BN3 not overlapped by the photoresists PR5 may be isotropically removed.

In the current process, the first bank layer BN1 overlapping the hole HOL2 may be exposed. The hole HOL2 may overlap or correspond to an area between emission areas EA, such as the non-emission area NLA. The hole HOL2 may be a preliminary recess in the bank which is between the emission areas EA.

Although not illustrated in the drawings, the photoresists PR5 may be removed through an ashing process.

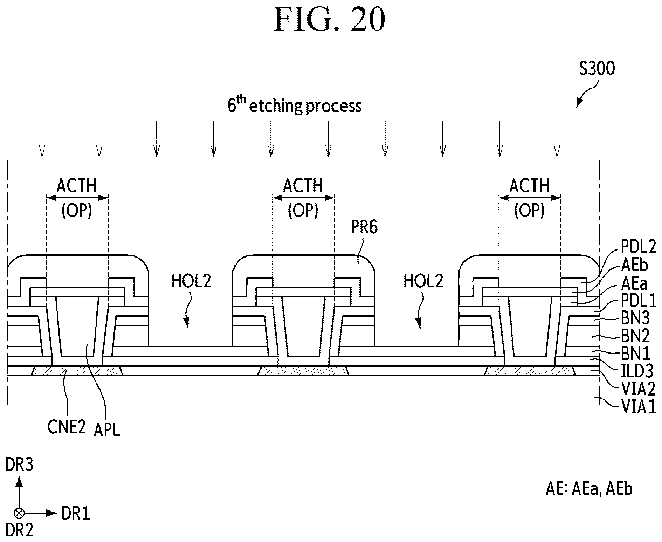

Next, as illustrated in FIG. 20, photoresists PR6 as sixth photoresists are formed on the anodes AE and the second element insulating layer PDL2, and a sixth etching process is performed. In the current process, a plurality of photoresists PR6 may be formed and may be located in the portions overlapping the anode contact holes ACTH. The photoresists PR6 may entirely cover upper surfaces of the anodes AE and the second element insulating layer PDL2. For example, the sixth etching process may be performed as a wet etching process. Redundant descriptions will be omitted.

In the current process, the second bank layer BN2 and the third bank layer BN3 including different metal materials may have different etch selectivities. Specifically, the third bank layer BN3 may have higher etch resistance than the second bank layer BN2 in the same etching process. In other words, the second bank layer BN2 may include a material having a higher etch rate than that of the third bank layer BN3 in the same etching process.

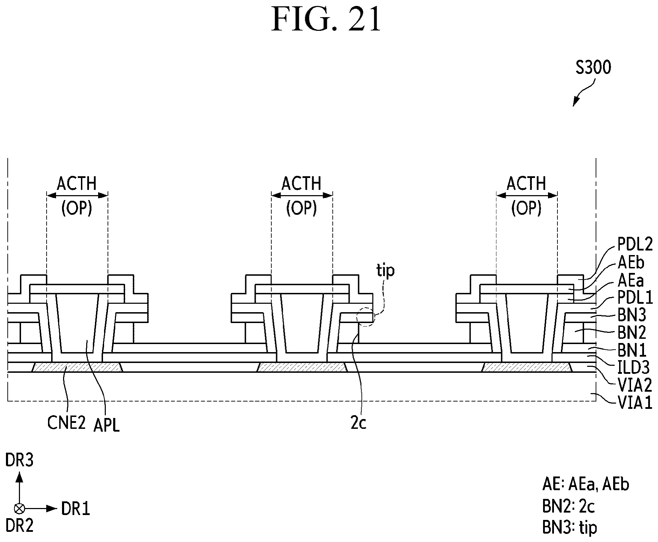

Therefore, as illustrated in FIG. 21, at each of the bank recesses, the third bank layer BN3 may include tips protruding more than first side surfaces 2c of the second bank layer BN2 in the first direction DR1. The first element insulating layer PDL1 and the second element insulating layer PDL2 may overlap the tips of the third bank layer BN3 in the third direction DR3. Redundant descriptions will be omitted.

Although not illustrated in the drawings, the photoresists PR6 may be removed through an ashing process.

The stacked structure in FIG. 21 may be a base structure on which light emitting elements may be provided. With reference to a common surface, such as the substrate SUB or the transistor layer TFTL, the stacked structure may provide a protruded structure at the emission areas EA (and/or the opening OP and/or the anode contact holes ACTH), while providing a recessed structure at the non-emission area NLA between the emission areas EA. The light emitting elements ED may be provided on the base structure provided in the operations of FIGS. 11 to 21.

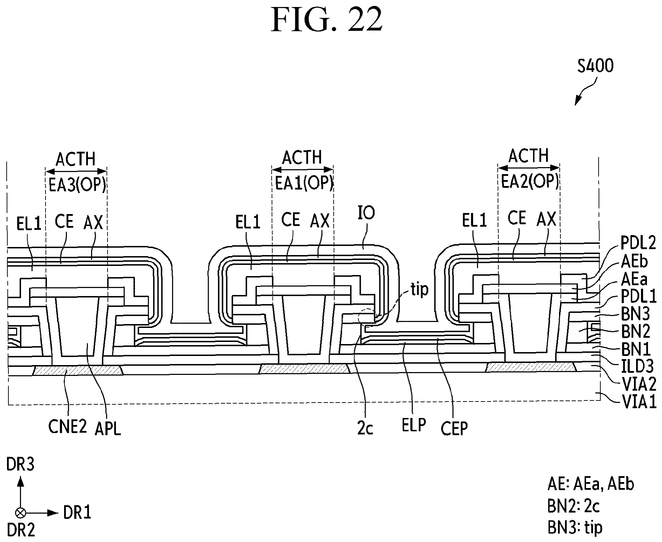

FIGS. 22 through 25 are cross-sectional views illustrating operation S400 of FIG. 10.

The forming of the light emitting layer EL, the cathode CE, the auxiliary electrode AX and the element inorganic layer IO on the anode AE (operation S400) will be described with reference to FIGS. 22 through 25.

First, preliminary (material) layers of a first light emitting layer EL1, a cathode CE, and an auxiliary electrode AX are deposited on the anodes AE to form a first light emitting element ED1.

In the current process, a process of forming the first light emitting layer EL1 may be performed through a thermal deposition process. In the current process, a material which forms the first light emitting layer EL1 may be formed not only on an anode AE overlapping a first emission area EA1, but also on anodes AE located in portions overlapping a second emission area EA2 and a third emission area EA3. The first light emitting layers EL1 located in the portions overlapping the first through third emission areas EA1 through EA3 may be spaced apart from each other.

In addition, the material which forms the first light emitting layer EL1 may also be formed on the first bank layer BN1 within the bank recess at the non-emission area NLA. The material which forms the first light emitting layers EL1 located on the anodes AE and the material which forms the first light emitting layer EL1 located on the first bank layer BN1 may be spaced apart from each other. The material which forms the first light emitting layer EL1 located on the first bank layer BN1 may be referred to as an organic pattern ELP. Here, the pattern of the first light emitting layer EL1 and the organic pattern ELP may be in a same layer as each other, such as being respective portions of a same material layer. The first light emitting layer EL1 and the organic pattern ELP may be disconnected from each other.

As being in a same layer, elements may be formed in a same process and/or include a same material as each other, elements may be respective portions of a same material layer, elements may be on a same layer by forming an interface with a same underlying or overlying layer, elements may be coplanar with each other or be disposed in a same thickness, etc., without being limited thereto.

In the current process, a process of forming the cathode CE may be performed through a thermal deposition process or a sputtering process. The process of forming the cathode CE may have higher step coverage characteristics than the process of forming the first light emitting layer EL1. Therefore, the cathode CE may entirely cover the first light emitting layer EL1.

In the current process, a material which forms the cathode CE may be formed not only on the first light emitting layer EL1 overlapping the first emission area EA1, but also on the first light emitting layers EL1 located in the portions overlapping the second emission area EA2 and the third emission area EA3. The cathodes CE located in the portions overlapping the first through third emission areas EA1 through EA3 may be spaced apart from each other.

In addition, the material which forms the cathode CE may be formed not only on the first light emitting layers EL1 but also on the organic pattern ELP. The material which forms the cathodes CE located on the first light emitting layers EL1 and the material which forms the cathode CE located on the organic pattern ELP may be spaced apart from each other. The material which forms the cathode CE formed on the first bank layer BN1 may be referred to as an electrode pattern CEP. Here, the pattern of the cathode CE and the electrode pattern CEP may be in a same layer as each other, such as being respective portions of a same material layer. The cathode CE and the electrode pattern CEP may be disconnected from each other.

In the current process, the cathodes CE may contact end surfaces of the tips of the third bank layer BN3. Redundant descriptions will be omitted.

A process of forming the auxiliary electrode AX may be performed through a sputtering process. The process of forming the auxiliary electrode AX may have higher step coverage characteristics than the process of forming the cathode CE. Therefore, a preliminary form of the auxiliary electrode AX may be formed over the entire surface. In other words, the auxiliary electrode AX may entirely cover the cathodes CE.

In the current process, a material which forms the auxiliary electrode AX may contact the tips of the third bank layer BN3 and the first side surfaces 2c of the second bank layer BN2. Redundant descriptions will be omitted. The preliminary layer of the material which forms the auxiliary electrode AX may be continuously disposed along the stacked structure, both in the bank recesses and over the protruded structure.

Next, a preliminary form of an element inorganic layer IO is formed on the auxiliary electrode AX. The element inorganic layer IO may cover a layered structure thereunder with a uniform thickness along the profile of the structure and may cover the entire auxiliary electrode AX.

In the current process, the element inorganic layer IO may be formed through a layer forming process (e.g., a deposition process) for forming at least one of the inorganic materials described above. The preliminary layer of the material which forms the element inorganic layer IO may be continuously disposed along the stacked structure, both in the bank recesses and over the protruded structure.

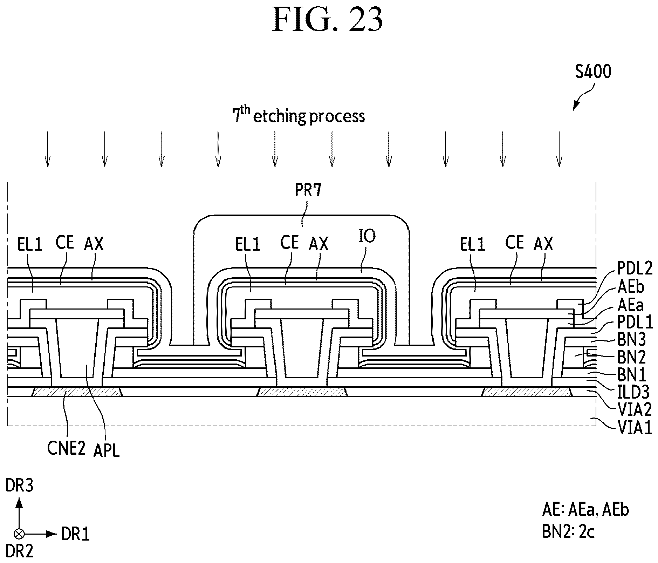

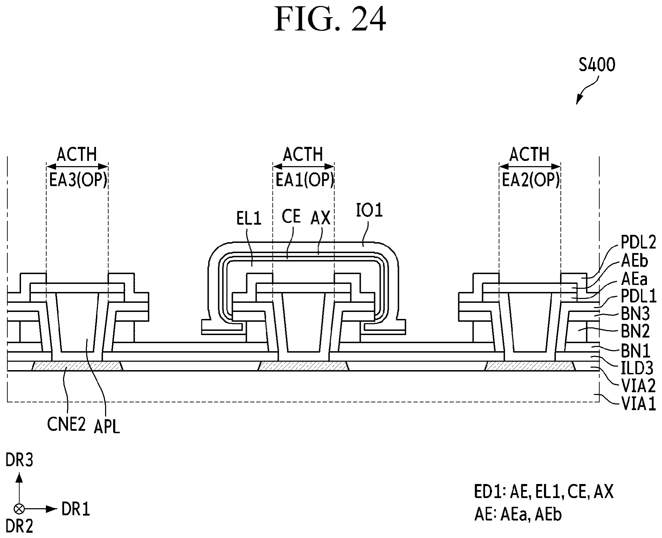

Next, as illustrated in FIGS. 23 and 24, a photoresist PR7 as a seventh photoresist is formed in a portion overlapping the first emission area EA1 and the periphery of the first emission area EA1, and a seventh etching process is performed using the photoresist PR7 as a mask.

In the current process, thickness portions of the material which forms the first light emitting layers EL1, the material which forms the cathodes CE, the material which forms the auxiliary electrode AX, and the material which forms the element inorganic layer IO not overlapped by the photoresist PR7 may all be removed at once. Accordingly, the anode AE overlapping the second emission area EA2 and the anode AE overlapping the third emission area EA3 may be exposed again, and the element inorganic layer IO may be formed in the form of a first element inorganic layer IO1.

As a result, the first light emitting element ED1 and the first element inorganic layer IO1 located in the portion overlapping the first emission area EA1 may be formed as a (first) light emission structure.

Next, preliminary material layers for forming a second light emitting layer EL2, a cathode CE, an auxiliary electrode AX, and an element inorganic layer IO are formed on the anode AE overlapping the second emission area EA2 by repeating the above-described process. Through the current process similar to the structures shown in FIGS. 22 to 24, a second light emitting element ED2 and a second element inorganic layer IO2 overlapping the second emission area EA2 may be formed.

In addition, preliminary material layers for forming a third light emitting layer EL3, a cathode CE, an auxiliary electrode AX, and an element inorganic layer IO are formed on the anode AE overlapping the third emission area EA3 by repeating the above-described process again. Through the current process again similar to the structures shown in FIGS. 22 to 24, a third light emitting element ED3 and a third element inorganic layer IO3 overlapping the third emission area EA3 may be formed.

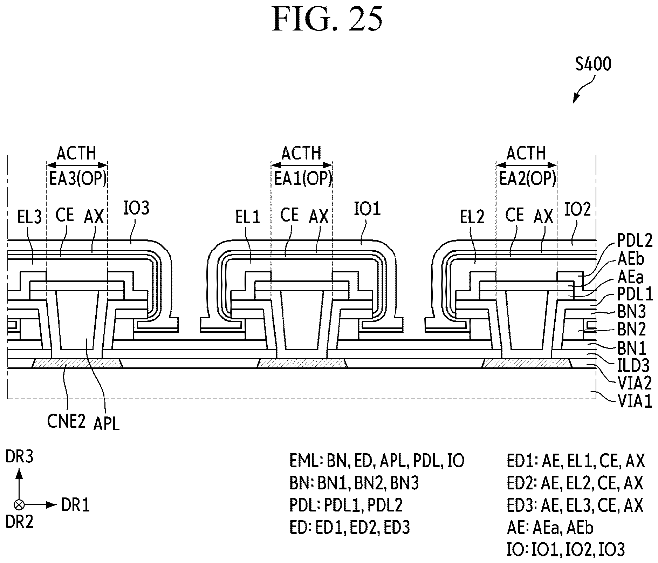

As a result, referring to FIG. 25, the display element layer EML overlapping the anode contact holes ACTH illustrated in FIG. 5 may be formed. Redundant descriptions will be omitted.

In the display device 10 of the embodiment, since the third bank layer BN3 as the uppermost thickness portion of the bank includes the tips, material patterns of the first light emitting layer EL1, the second light emitting layer EL2, and the third light emitting layer EL3 which are spaced apart from each other can be formed in the portions respectively overlapping the first through third emission areas EA1 through EA3, without using a fine metal mask.

In addition, in the display device 10 of the embodiment, since the third bank layer BN3 includes the tips, material patterns of the cathodes CE spaced apart from each other can be formed in the portions overlapping the first through third emission areas EA1 through EA3 without using a fine metal mask. Accordingly, the display device 10 of the embodiment can be easily fabricated.

In addition, the display device 10 of the embodiment may flatten a step included in the first conductive layer AEa having a recessed structure, by including the anode planarization layer APL, which fills the anode contact holes ACTH, in the portions overlapping the anode contact holes ACTH. Accordingly, an uppermost surface of the second conductive layer AEb of each anode AE may be formed to have a substantially flat surface, allowing materials of the first, second or third light emitting layer EL1, EL2 or EL3 to be formed to a uniform thickness. Therefore, the reliability defect (e.g., the light emitting layer shadow defect) of the display device 10 can be solved. Other redundant descriptions will be omitted.

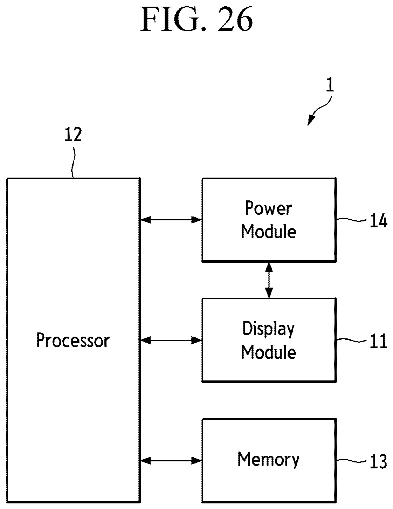

FIG. 26 is a block diagram of an electronic device 1 according to an embodiment.

Referring to FIG. 26 in addition to FIGS. 1 through 25, the display devices 10, 30 and 50 according to the embodiments can be applied to various electronic devices 1. An electronic device 1 according to an embodiment includes at least one of the above-described display devices 10, 30 and 50 and may further include modules or devices having other additional functions, in addition to the display device 10, 30 or 50.

The electronic device 1 according to the embodiment may include a display module 11, a processor 12, a memory 13, and a power module 14.

The processor 12 may include at least one of a central processing unit (CPU), an application processor (AP), a graphic processing unit (GPU), a communication processor (CP), an image signal processor (ISP), and a controller.

The memory 13 may store data information necessary for the operation of the processor 12 or the display module 11. When the processor 12 executes an application stored in the memory 13, an image data signal and/or an input control signal may be transmitted to the display module 11, and the display module 11 may process the received signal and output image information through a display screen.

The power module 14 may include a power supply module such as a power adapter or a battery device and a power conversion module which generates power necessary for the operation of the electronic device 1 by converting power supplied by the power supply module.

At least one of the components of the electronic device 1 described above may be included in a display device among display devices 10, 30 and 50 according to the embodiments described above. In addition, some of individual modules functionally included in one module may be included in the display device among display devices 10, 30 and 50, and other modules may be provided separately from the display device. For example, the display device may include the display module 11, and the processor 12, the memory 13 and the power module 14 may be provided not in the display device but in the form of other devices within the electronic device 1.

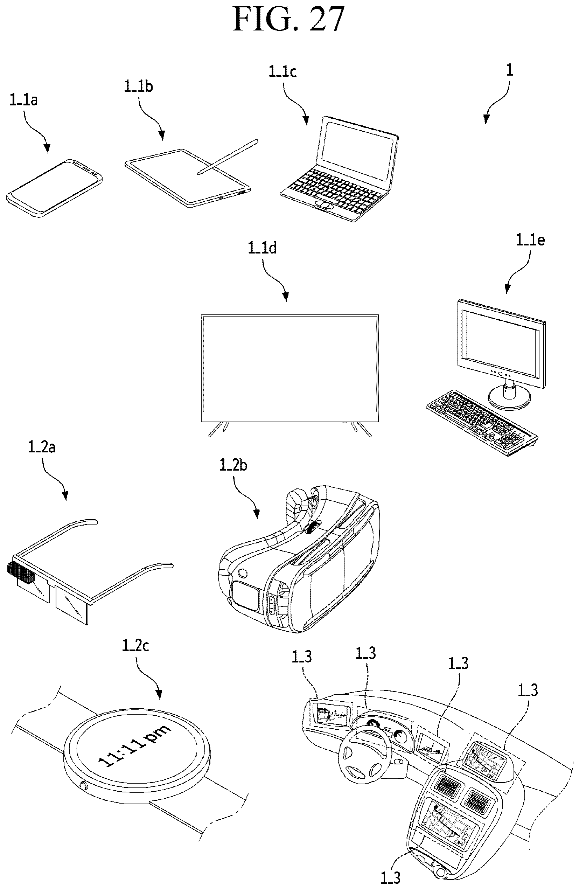

FIG. 27 is a schematic diagram of electronic devices according to various embodiments.

Referring to FIG. 27, various electronic devices 1 to which the display devices 10, 30 and 50 according to the embodiments are applied may include not only image display electronic devices such as a smartphone 1_1a, a tablet PC 1_1b, a laptop 1_1c, a television 1_1d and a desk monitor 1_1e, but also wearable electronic devices including display modules, such as smart glasses 1_2a, a head mounted display 1_2b and a smart watch 1_2c, and vehicle electronic devices 1_3 including display modules, such as a center information display (CID) and a room mirror display placed on an instrument panel, center fascia and dashboard of a vehicle.

According to a display device according to one or more embodiment, an electronic device 1 using the display device, and a method of fabricating (or providing) the display device, it is possible to provide a high-resolution image and solve a reliability defect of a light emitting element included in the display device.

In an embodiment, an electronic device 1 includes a display device, and a display module, a processor, a memory or a power module connected to the display device. The display device includes a substrate including an emission area EA and a non-emission area NLA, a bank structure BN which is on the substrate and in which an anode contact hole ACTH is defined in the emission area EA, the bank structure BN having a side surface defining the anode contact hole ACTH and an overhang structure which is in the non-emission area NLA, a first element insulating layer PDL1 on the bank structure BN and extended into the anode contact hole ACTH to cover the side surface of the bank structure BN, an anode AE of a light emitting element ED, on the first element insulating layer PDL1 and in the emission area EA, the anode AE including a first conductive layer AEa and a second conductive layer AEb facing each other in the emission area EA, an anode planarization layer APL between the first conductive layer AEa and the second conductive layer AEb in the emission area EA, the anode planarization layer APL including an organic material, and a second element insulating layer PDL2 covering an edge of the anode AE and in which an opening OP is defined overlapping the anode contact hole ACTH, the second element insulating layer PDL2 contacting the first element insulating layer PDL1.

The display device may further include a circuit layer connected to the light emitting element ED. The first conductive layer AEa may penetrate each of the first bank layer, the second bank layer and the third bank layer to define a portion of the anode AE which is exposed outside of the bank structure BN. Here, the light emitting element ED may be electrically connected to the circuit layer at the portion of the anode AE.

However, the effects of the present disclosure are not restricted to the one set forth herein. The above and other effects of the present disclosure will become more apparent to one of daily skill in the art to which the present disclosure pertains by referencing the claims.

## Claims

1. A display device (10, 30, 50) comprising:
a substrate (SUB) comprising an emission area (EA) and a non-emission area (NLA);
a bank structure (BN) which is on the substrate (SUB) and in which an anode contact hole (ACTH) is defined in the emission area (EA), the bank structure (BN) having a side surface defining the anode contact hole (ACTH) and an overhang structure which is in the non-emission area (NLA);
a first element insulating layer (PDL1) on the bank structure (BN) and extended into the anode contact hole (ACTH) to cover the side surface of the bank structure (BN);
an anode (AE) of a light emitting element (ED), on the first element insulating layer (PDL1) and in the emission area (EA), the anode (AE) comprising a first conductive layer (AEa) and a second conductive layer (AEb) facing each other in the emission area (EA);
an anode planarization layer (APL) between the first conductive layer (AEa) and the second conductive layer (AEb) in the emission area (EA), the anode planarization layer (APL) comprising an organic material; and
a second element insulating layer (PDL2) covering an edge of the anode (AE) and in which an opening (OP) is defined overlapping the anode contact hole (ACTH), the second element insulating layer (PDL2) contacting the first element insulating layer (PDL1).

2. The display device (10, 30, 50) of claim 1, wherein
the bank structure (BN) comprises:
a first bank layer (BN1), a second bank layer (BN2) and a third bank layer (BN3) in order from the substrate (SUB);
each of the first bank layer (BN1), the second bank layer (BN2) and the third bank layer (BN3) having a side surface defining a portion of the side surface of the bank structure (BN); and
the third bank layer (BN3) protrudes further than the side surface (2c) of the second bank layer (BN2) to define a tip of the overhang structure; and
the anode planarization layer (APL) penetrates the first bank layer (BN1), the second bank layer (BN2) and the third bank layer (BN3), in the emission area (EA).

3. The display device (10, 30, 50) of claim 2, wherein the first conductive layer (AEa) is spaced apart from the first bank layer (BN1), the second bank layer (BN2) and the third bank layer (BN3) with the first element insulating layer (PDL1) therebetween.

4. The display device (10, 30, 50) of claim 3, wherein
the first conductive layer (AEa) comprises a step defined therein, and
the anode planarization layer (APL) which is between the first conductive layer (AEa) and the second conductive layer (AEb) in the emission area (EA) flattens the step of the first conductive layer (AEa).

5. The display device (10, 30, 50) of any one of claims 2 to 4, further comprising:
a first light emitting layer (EL1) of the light emitting element (ED) which is on the anode (AE) and covering an entirety of the second element insulating layer (PDL2);
a cathode (CE) of the light emitting element (ED) which is on the first light emitting layer (EL1); and
an auxiliary electrode (AX) which is on the cathode (CE) and contacting the tip of the third bank layer (BN3).

6. The display device (10, 30, 50) of claim 5, wherein the auxiliary electrode (AX) contacts the side surface (2c) of the second bank layer (BN2) and is spaced apart from the first bank layer (BN1) in a direction perpendicular to the substrate (SUB).

7. The display device (10, 30, 50) of any one of claims 1 to 6, wherein the anode planarization layer (APL) contacts the first conductive layer (AEa) and the second conductive layer (AEb) and is completely surrounded by the first conductive layer (AEa) and the second conductive layer (AEb), optionally wherein the second conductive layer (AEb) comprises:
a first portion (b11) which overlaps the anode planarization layer (APL), and
a second portion (b12) which overlaps and contacts the first conductive layer (AEa).

8. The display device (10, 30, 50) of any one of claims 1 to 7, wherein
the first conductive layer (AEa) and the second conductive layer (AEb) contact each other in the non-emission area (NLA), and
the anode planarization layer (APL) does not overlap the non-emission area (NLA).

9. The display device (30, 50) of any one of claims 1 to 8, wherein the anode planarization layer (APL) comprises a first surface (p1) which faces the second conductive layer (AEb) and is curved, optionally wherein:
(i) the first surface (p1) is convex in a direction toward the second conductive layer (AEb); or
(ii) the first surface (p1) is concave in a direction toward the substrate (SUB).

10. A method of providing a display device (10, 30, 50), the method comprising:
providing a first element insulating layer (PDL1) on a bank structure (BN);
providing an anode contact hole (ACTH) which penetrates the first element insulating layer (PDL1) and the bank structure (BN) and overlaps an emission area (EA) of the display device (10, 30, 50);
providing an anode (AE) of a light emitting element (ED), on the first element insulating layer (PDL1), in the emission area (EA) by providing:
a first conductive layer (AEa) of the anode (AE), the first conductive layer (AEa) extending into the anode contact hole (ACTH) to form a recess in the first conductive layer (AEa),
an anode planarization layer (APL) on the first conductive layer (AEa), in the anode contact hole (ACTH), and
a second conductive layer (AEb) of the anode (AE) which overlaps both the first conductive layer (AEa) and the anode planarization layer (APL);
providing a second element insulating layer (PDL2) in which an opening (OP) is defined overlapping the anode contact hole (ACTH), on the first element insulating layer (PDL1) and the second conductive layer (AEb); and
providing a light emitting layer (EL1) of the light emitting element (ED), a cathode (CE) of the light emitting element (ED), an auxiliary electrode (AX) and an element inorganic layer (IO) overlapping on the anode (AE), in the emission area (EA).

11. The method of claim 10, wherein the providing of the anode (AE) comprises:
providing the anode planarization layer (APL) extended out of the recess in the first conductive layer (AEa) to define an extended portion of the anode planarization layer (APL),
removing the extended portion by chemical mechanical polishing to provide a polished upper surface of the anode planarization layer (APL) which overlaps the anode contact hole (ACTH), and
contacting the second conductive layer (AEb) with the polished upper surface of the anode planarization layer (APL).

12. An electronic device (1) comprising:
a display device (10, 30, 50); and
at least one of a display module (11), a processor (12), a memory (13) and a power module (14) connected to the display device (10, 30, 50),
wherein the display device (10, 30, 50) comprises:
a substrate (SUB) comprising an emission area (EA) and a non-emission area (NLA);
a bank structure (BN) which is on the substrate (SUB) and in which an anode contact hole (ACTH) is defined in the emission area (EA), the bank structure (BN) having a side surface defining the anode contact hole (ACTH) and an overhang structure which is in the non-emission area (NLA);
a first element insulating layer (PDL1) on the bank structure (BN) and extended into the anode contact hole (ACTH) to cover the side surface of the bank structure (BN);
an anode (AE) of a light emitting element (ED), on the first element insulating layer (PDL1) and in the emission area (EA), the anode (AE) comprising a first conductive layer (AEa) and a second conductive layer (AEb) facing each other in the emission area (EA);
an anode planarization layer (APL) between the first conductive layer (AEa) and the second conductive layer (AEb) in the emission area (EA), the anode planarization layer (APL) comprising an organic material; and
a second element insulating layer (PDL2) covering an edge of the anode (AE) and in which an opening (OP) is defined overlapping the anode contact hole (ACTH), the second element insulating layer (PDL2) contacting the first element insulating layer (PDL1).

13. The electronic device (1) of claim 12, wherein
the bank structure (BN) comprises:
a first bank layer (BN1), a second bank layer (BN2) and a third bank layer (BN3) in order from the substrate (SUB);
each of the first bank layer (BN1), the second bank layer (BN2) and the third bank layer (BN3) having a side surface defining a portion of the side surface of the bank structure (BN); and
the third bank layer (BN3) protrudes further than the side surface (2c) of the second bank layer (BN2) to define a tip of the overhang structure; and
the anode planarization layer (APL) penetrates the first bank layer (BN1), the second bank layer (BN2) and the third bank layer (BN3), in the emission area (EA).

14. The electronic device (1) of claim 13, wherein the first conductive layer (AEa) is spaced apart from the first bank layer (BN1), the second bank layer (BN2) and the third bank layer (BN3) with the first element insulating layer (PDL1) therebetween, optionally wherein
the first conductive layer (AEa) comprises a step defined therein, and
the anode planarization layer (APL) which is between the first conductive layer (AEa) and the second conductive layer (AEb) in the emission area (EA) flattens the step of the first conductive layer (AEa).

15. The electronic device (1) of any one of claims 12 to 14, wherein the anode planarization layer (APL) contacts the first conductive layer (AEa) and the second conductive layer (AEb) and is completely surrounded by the first conductive layer (AEa) and the second conductive layer (AEb), optionally wherein the second conductive layer (AEb) comprises:
a first portion (b11) which overlaps the anode planarization layer (APL) and a second portion (b12) which overlaps and contacts the first conductive layer (AEa).
